# EUROPEAN PATENT APPLICATION

(11) **EP 4 535 934 A1**
(43) Date of publication of application: **09.04.2025**
(21) Application number: 23211208.6
(22) Date of filing: 21.11.2023
(51) Int. Cl.: H05K 3/12, B33Y 10/00

(54) **METHOD AND DEVICE FOR ADDITIVE MANUFACTURING OF ELECTRONIC CIRCUITS**

(30) Priority: 04.10.2023 DE 102023127005
(71) Applicant: Albert-Ludwigs-Universität Freiburg, 79098 Freiburg (DE); Hahn-Schickard-Gesellschaft für angewandte Forschung e. V., 70569 Stuttgart (DE)
(72) Inventor: Khan, Zeba, 79117 Freiburg (DE); Koltay, Peter, 79117 Freiburg (DE); Shu, Zhe, 79106 Freiburg (DE)
(74) Representative: Hertin und Partner Rechts- und Patentanwälte PartG mbB

(57) **Abstract**

The invention relates to a method of additive manufacturing of an electronic circuit. The method comprises the steps of providing a printing device comprising a build plate; a first printhead configured for printing a conductive molten metal and a second printhead configured for printing a non-conductive material. The method further comprises printing the electronic circuit by printing conductive elements from the conductive molten metal using the first printhead and printing a non-conductive structure using the second printhead of the printing device. In a further aspect, the invention relates to a printing device for the additive manufacturing of an electronic circuit. The printing device comprises: a build plate, a first printhead configured for printing conductive elements from a conductive molten metal and a second printhead configured for printing a non-conductive structure from a dielectric material.

## Description

The present invention enables the direct manufacturing of electronic circuits, for example printed circuit boards (PCB) via additive manufacturing.

The invention preferably relates to a method of additive manufacturing of an electronic circuit. The method preferably comprises the steps of providing a printing device comprising a build plate; a first printhead configured for printing a conductive molten metal and a second printhead configured for printing a non-conductive material; and preferably means for independently moving the first printhead and the second printhead in an x-y-plane relative to the build plate and/or moving the build plate in an x-y-plane relative to the first and/or second printhead. The method further comprises printing the electronic circuit by printing conductive elements from the conductive molten metal using the first printhead and printing a non-conductive structure using the second printhead of the printing device. In a further aspect, the invention preferably relates to a printing device for the additive manufacturing of an electronic circuit by the inventive method. The printing device preferably comprises: a build plate and optionally a heater configured to melt a conductive metal provided in bulk form. The printing device further comprises a first printhead configured for printing conductive elements from a conductive molten metal and a second printhead configured for printing a non-conductive structure from a dielectric material. Optionally, the printing device comprises means for moving the first printhead and the second printhead in an x-y-plane relative to the build plate and/or moving the build plate in an x-y-plane relative to the first printhead and the second printhead.

### Background and State of the Art

Additive manufacturing (AM), so-called 3D printing, has re-shaped the manufacturing technologies with attractive alternatives to the traditional centralized, subtractive-based mass production. Further functionalities like multi-material AM (MMAM) will be essential for mainstream manufacturing. AM has revolutionized the way we create and fabricate objects across a wide spectrum of industries. This transformative technology has opened new avenues for design, production, and innovation by enabling the layer-by-layer construction of intricate and complex structures. AM provides numerous benefits such as customization and personalization at lower cost and rapid delivery [P1], decentralized and on-demand manufacturing [P2], material saving and minimized waste [P3], to name a few. In particular during the Covid pandemic, the localized on-demand production of personal protective equipment (PPE) as well as crucial medical parts exhibited the advantages of AM at the situation of the logistics and supply chain disruption and high demands on rapid delivery [P4]. Nevertheless, the wide application of AM is still limited to the use of materials of a single type such as polymer or metal etc., and most of these AM products serve pure mechanical functions such as a bike frame [P5], car jet engines, customized bodies for cars [P6], and personalized eyewear frames [P7]. Although there are numerous efforts, particularly in the last 10 years on developing multi-material 3D printing, the industry is heavily biased towards studying new materials and the investigation of the pure mechanical properties while lacking a focus on developing new technologies [P8]. On the contrary, adding further functionalities will be essential to push the evolution of the AM technology to be more widely adopted in the mainstream manufacturing [P9].

AM technology is thus limited in regard to its application to multi-material devices such as electronic circuits.

After decades of development, there is a mature and large scale of production of printed circuit boards via complex subtractive process steps that are summarized in the cited review articles [1, 2]. In general, this conventional process consists of a sequence of brushing, curing of an etching resistor, etching, resistor stripping, black oxide, hole drilling, de-smearing, plating through-hole, curing of plating resistor, circuit plating, solder plating, plating resistor stripping and Cu etching, solder stripping, solder mask printing, and hot air leveling that are carried out on a flat substrate, for example a so called FR4-board. As this is a complex process, it is mainly carried out in large factories with highly automated, dedicated equipments. Therefore, this conventional method leads to long design-to-product time, high costs and less flexibility in design exploitation. In all the processes, a large amount of (toxic) chemicals is involved and contaminated waste waters are produced. Therefore, additive manufacturing offers some general advantages over this established method, in particular regarding turn-around times, capital costs, design freedom and reduced material consumption.

There have been numerous efforts to use additive manufacturing for printing 2D and even 3D electronic circuits. These are summarized in the literature [3, 4]. Most approaches utilize a combination of multiple manufacturing techniques to integrate electronic circuits into 3D objects. Often conductive inks or pastes are used for the printing of conductive features. This leads to drawbacks such as a very limited layer thickness (a few hundred nanometers up to two micrometers), a drying process that emits toxic solvents, and the need for a sintering/curing step subsequent to the printing process. The conductive inks result in high electrical resistance, compatibility issues with the polymer substrates and have no possibility of being manufactured on one machine due to complex processes and high costs due to the expensive nanoparticle inks. Conductive inks are also known to suffer from long-term instability, "coffee-ring" effects during printing and first drop problems (the first droplets having inconsistent size and mass). Moreover, although the substrates are mostly in 3D shapes, the electrical circuits can only be provided on the outer surface of the 2D substrates or 3D objects.

Apart from the fabrication of 3D objects with conductive features by 3D-printing, the direct integration of electronic components to form completely functional electronic devices is also of high interest. Typical approaches for interconnecting conductive features and electrodes of integrated circuits (ICs) such as microchips and SMDs are summarized in the literature [5]. The most common method is using low-melting solder or solder paste to electrically connect the electronic components to the conductive tracks, but this requires an additional reflow process which limits the choice of substrates and 3D integration [6]. Other options are using conductive inks/adhesives with a combination of non-conductive adhesives, which lead to a higher process complexity and less mechanical stability [5].

Once a PCB is fabricated, it needs to be populated with electronic components and form interconnections with electrical components such as transistors, resistors, and capacitors. Stencil printing is a mature traditional solder printing process that has been widely used for soldering devices onto electronic circuits. However, stencil printing has a limiting factor depending on the size of the electrical and electronics component used. Moreover, stencil printing can only be applied on the flat surface such as PCB boards and cannot be integrated on 3D solder printing due to its mask-based principle. The concept known for soldering the electronic components onto a PCB board has been summarized in the cited literature [7, 8, 9].

Min-Saeng Kim, et.al [7] presents an approach for directly connecting all the electrical connections via rapid prototyping. Solder is used to form interconnections and Polycaprolactone (PCL) is used to form a polymer insulator. However, this method is restricted to the 2D interconnection on the backside of universal PCB boards and are not applicable to microchips with SMD/SMT layouts. In another study, Wang L, et al. [8] resolved the issue of populating electronic and electrical components on the PCB board by first soldering the components indirectly to form an intermetallic layer and then placing the conductive ink of the interconnection on top of it. Although the result increased the connecting reliability, it introduced indirect soldering which is prone to multiple errors and reduces automation in the production of printed electronics. Furthermore, this method highly relies on the special low-melting solder and silicone. 24 hours curing of each silicone layer is required before the metal layer deposition. Goh, Guo Liang, et. al [9] used carbon conductive paint to connect the electronic components since it adheres well to the underlying substrate and forms a continuous track. However, it has high resistivity and is therefore not suitable for large functional electronics in 3 dimensions.

Attempts to combine the additive manufacturing of conductive and non-conductive materials are currently focused on using metal-polymer hybrid filament to enhance the properties of polymer materials because of the insufficient bonding of polymer and metal via FFF methods. Thus, more efforts have been exploited on the combination of various printing technologies to bring together the printing of metal and polymer. DeNava et al reports on combining the stereolithography (SL) 3D printing of dielectric materials, off-axis direct writing of 3D conductive routings and off-axis electronic component placement to produce a 3D magnetic flux sensor [P15] and also later improved designs [P16]. However, the multi-material additive manufacturing was done in separate steps and as a result the conductive features were only deposited onto the flat surface or at best over the curved edges of the product. Espalin et al reports another multi-material additive manufacturing where copper wires are embedded in polymer produced from 2 FFFs and a CNC, for lower electrical resistance. Again, the manufacturing processes were executed one after another. Although embedding the copper wire leads to superior electrical conductivity, the geometrical design freedom was highly restricted and additional welding or soldering was required for interconnections and contacting components. Similarly, there are some other reported examples of combinations of technologies such as injection molding of polymer and direct writing of conductive inks [P17], inkjet printing (polyJet) of dielectrics and dispensing of conductive ink [P18], where the printed electrical circuits are either on the surface of the PCB or embedded via additional assembly steps.

In orderto achieve maximum design freedom in multi-material additive manufacturing with electrical functionalities, which are customizable to the desired form and shape of a PCB, a hybrid printing platform combining dielectric and conductive material AM is required. Lewis group from Harvard University [P19] is the pioneer in this field and founded a start-up company to commercialize the low-cost hybrid 3D printer combined direct ink writing of conductive interconnects and 3D printed polymers via FFF. With this hybrid printing system, a complex freeform design with embedded electronics, such as a quad copter drone can be 3D-printed. The technology uses roomtemperature cured silver inks (comprising silver as dispersed particles rather than in bulk form) to circumvent the high temperature curing issues of typical nanoparticle or micro-flecks metal inks [P10] in a hybrid printing process, and the printed conductive wires have a conductivity of 50 × 10⁻⁸ Ωm for wire resolution of 250µm [P9]. Nevertheless, this product is discontinued at the time of writing, most likely due to the high cost of the silver inks [P20]. The DragonFly 2020 Pro 3D printer from nano-dimension can directly manufacture a multi-layer PCB via 3D inkjet printing of both dielectric and conductive materials [P21, P22]. It provides a high electrical conductivity (5.73 × 10⁻⁸ Ωm, around 30% of Copper) of conductive wires and can print vertical vias in small heights. Due to the long build time of inkjet printing, the technology is currently restricted to thin AM of PCBs in 2.5D (two-and-a-half dimensions). Other research for hybrid printed electronics includes integration of FFF of polymers with Intense Pulsed Light sintering (IPL) of silver nano-particles [P23]. Nanoparticles are printed with the help of a syringe and subsequent IPL with xenon lamp light. Although this technique shows excellent hybrid printing of functional electronics, this process requires sintering, it could limit the range of polymer materials that can be used in combination with this technology.

In the most state-of-the-art multi-material additive manufacturing of conductive material, the nanoparticle-based metal inks or silver paste are used. The printed features required a drying step to evaporate the solvent and a few sintering steps to functionalize the printed inks [P24]. The used solvents could cause the ink to percolate between the printed polymer layers and cause electrical short-circuits [P13]. In addition, it is difficult to control the spread of the ink, which is critical when trying to print conductive features with small line spacing, such as interdigitated circuits [P25]. Another aspect is the difference in resolution of printed features between the polymer and the ink, which causes unsuccessful prints or creates the need for additional fixes or specific design restrictions [P13]. The use of specific design guidelines limits the design freedom inherently presented by additive manufacturing technology. Although the inks are widely used for PE, they are limited to the world of two-dimensionality and unsuitable for printing three-dimensional free-form electronic components. Furthermore, not only are the inks a limiting element for producing high-power electronics, but they are also a bottleneck in the current trend of green electronics since they require chemically treated substrates for good adhesion, which means more and more chemical waste is disposed of in the environment [P26].

There is therefore a need for alternative methods to manufacture a printed circuit, in particular with improved conductivity, resolution and design freedom, in particular to permit the manufacture of three-dimensional forms. There is further a need for ecological and safe manufacturing methods. There is a need for improved design freedom in distributing electrical circuits in three-dimensional polymer models easily printable on a minimum of machinery or production stations. There is also a need to provide a method of green manufacturing of circuit boards, preferably involving layer-by-layer printing of polymer and conductive features without using any subtractive method or producing any residual waste. There is additionally a need for further developments in high-power multi-material additive manufacturing (MMAM) and printed electronics (PE) in the form of robust and reliable electrically conductive features.

### Object of the Invention

The object of the invention is to provide a printing device and a method of additive manufacturing of an electronic circuit without the disadvantages of the prior art. In particular, it is an objective of the invention to provide improved methods and devices for printing a circuit with improved conductivity, resolution, and design freedom, especially to allow the manufacture of multi-layered PCBs with three-dimensional electronic circuits. A further object of the invention is improving manufacturing safety and the reduction of wastes, in particular toxic wastes. Yet another object of the invention is the reduction of turnaround times from design to manufacture of circuit boards and the efficient production of prototypes and short series.

### Summary of the Invention

In a first aspect, the invention relates to a method of additive manufacturing of an electronic circuit. The method comprises the steps of providing a printing device comprising a build plate; a first printhead configured for printing conductive molten metal and a second printhead configured for printing a non-conductive material; printing the electronic circuit by printing conductive elements from the conductive molten metal using the first printhead and printing a non-conductive structure using the second printhead of the printing device.

The function of the first printhead may be performed by one or more printheads, or by at least one printhead comprising one or more nozzles. Similarly, the function of the second printhead may be performed by one or more printheads, or by at least one printhead comprising one or more nozzles. Additional printheads with further functions may also be present on the same printing device or another printing device.

The conductive molten metal may be a solid or a liquid at room temperature. The conductive molten metal may be provided to the printer and/or the first printhead in a solid or liquid form. In some embodiments, the conductive molten metal is provided in a solid form and melted *in-situ* in the printing device (or "printer"), such as to be deposited in liquid form. In further embodiments, the conductive molten metal is deposited as a metal powder and melted during or after deposition, preferably by selective laser melting (SLM). In other embodiments a metal, which is liquid at room temperature may be used (e.g. an Indium Gallium Alloy, in particular Galinstan) may be used, which does not need be melted by applying an additional heating. Instead, such metals are in a liquid state at room temperature.

The technology presented here is preferably referred to as `hybrid 3D printing' because it allows conductive material (e.g. conductive metal as electrical tracks) and non-conductive supporting material (e.g. polymer base as the substrate) to be combined in a preferably fully automated process. The present invention preferably constitutes a rapid prototyping and/or manufacturing approach to the production of PCBs and solves the problem of long design-to-product life cycle, high cost of design exploitation, and high time and cost for small series prototypes/production. Furthermore, compared to the conventional subtractive and centralized PCB manufacturing technology based on lithographic techniques, this hybrid 3D printing device and method preferably provides high data and design protection, decentralized `in-house` manufacturing, and reduces toxic waste and waste water by the additive manufacturing process.

The invention solves in particular the problem of poor conductance of elements printed using the printable inks according to the prior art by printing the conductive elements from a molten metal. Such a metal may have a greater conductivity and lower resistance in comparison to the printable inks, which is further improved by the greater cross-sectional sizes of the conductive elements which can be achieved by printing molten metals. The performance of the printed PCBs is thus improved in comparison to the prior art.

In contrast, due to their low viscosities (in particular due to a low metal concentration in the solution) and high costs, the printable conductive inks of the prior art are typically only printable in low layer thicknesses. For example, the ink based conductive elements may have heights between 100 nm to a few micrometers with a line width of the order of 100 µm. While this may result in a low electrical conductance of the ink based conductive elements, this may also present mechanical issues. Conductive elements formed from printable inks are thus provided on a surface of a material and cannot, for example, be effectively partially embedded in a non-conductive material, e.g. due to difficulties in precise layer stacking of inks. This challenge is overcome by the present invention which allows for conductive elements to be printed from a bulk material (the molten metal) which may have similar rheological properties and therefore a similar or identical thickness to the dielectric material. The conductive elements can thus be at least partially embedded within a layer of dielectric material of similar thickness. The conductive elements may thus be provided with high aspect ratios (e.g. a linewidth and height of approx. 100 µm, but a length in the order of millimeters) resulting in a high conductance, but nevertheless in a mechanically stable manner.

The invention further improves the speed of manufacture of prototypes and short series due to the possibility of printing both material types (conductive and non-conductive) of the printed circuit board using the same printer, said same printer comprising the first and second printhead at the same time. In particular, this may mean that both components are built up onto the same build plate, in particular a print bed, without being moved to a different build plate between printing steps. A one-stop manufacturing of both the conductive and non-conductive portions of the PCB is thus possible. This is especially economical as capital costs for providing multiple work stations with different manufacturing equipment according to the prior art can be avoided. Instead, only a single printing device is required, the printing device not necessarily being specialized for the manufacture of a particular prototype or series. Instead, the printing device can be used to produce PCBs of different designs without significant hardware changes. In addition, the precision and quality of manufacture of the PCB is improved by the one-stop printing device. In particular, the lack of movement of already-printed components from the build plate between printing steps reduces the introduction of errors. Further components or layers printed onto an intermediate product do not need to be precisely calibrated to the position of the existing intermediate product which is already known. Alignment issues are thus avoided.

An additional advantage of the provision of a single printing device for printing both conductive and non-conductive material is that confidential information relating to the PCB design need not be shared with a number of facilities. Instead, sensitive data may be kept local.

Compatibility issues between the conductive elements and the non-conductive material are additionally resolved by the invention, such that the produced circuit board is especially stable. A good fit is provided between the non-conductive material and the conductive elements. The fit may be improved when printing both conductive and non-conductive material using the same printing device as one or more materials may still be soft while another is being deposited. This allows the soft material to either fill an available cavity and/or to deform to accommodate newly deposited material, such that unwanted gaps are eliminated. The finished PCB is thus especially robust.

Moreover, the invention provides a much safer and more ecological method of producing printed circuit boards due to the lack of volatile components often used in printable conductive inks. Toxic chemicals and flammable materials or dusts involved in conventional etching, stripping, hot air leveling and the like could be avoided such that the inventive method could be carried out in virtually any environment. The use of large amounts of water to remove material or toxic wastes is further reduced or eliminated.

The invention further provides a high degree of design freedom as the first and the second printheads may preferably both be movable in the x-y-plane. Movement of the printheads may be independent of one another. This allows for rapid manufacture of complex designs. The first and second printheads could be surprisingly configured for substantially identical layer thicknesses. This is typically not possible when conductive inks are used in combination with printed non-conductive materials as the conductive ink typically has a very low thickness. The inventive method could thus rapidly provide layered structures which were very stable. The layered structures could be configured to be substantially two-dimensional, two-and-half-dimensional or three-dimensional, as required.

The inventive method can also eliminate the need for post processing after printing as the hybrid printed product can be provided with an excellent finish and quality, as is explained in more detail with respect to the device and the concrete examples. Moreover, it preferably need not involve any high end processing with high cost investment.

As will be explained further with reference to the figures and examples, a preferred embodiment of the inventive method employs the in-house developed printer, named "Synkrótima", for one-stop printing of 3D dielectric parts with fully embedded and structured conductive features via Drop-on-Demand printing of molten metal. The printed conductive traces show 12 times lower electrical resistance of 5.7mΩmm⁻¹ at 230 µm linewidth than the lines from conductive inks according to the state of the art. Printed traces with 100 µm dot spacing revealed exemplary shape fidelity with a standard deviation of only 7 µm. Quantitative estimation of adhesion of metal traces to the dielectric material revealed a mean shear-off force of 7.2 N which is half of what is obtained for reflow soldered electronics. Demonstrators with embedded functional electrical circuits, directly interconnected components, and 3D out-of-plane metal structures were printed via Synkrótima (see further explanations in the detailed description outlining further technical advantages of the invention with reference to experiments carried out using preferred embodiments of the printing device and printing method).

The invention can in principle make use of any additive manufacturing technology (e.g. FFF, FDM, Polyjet etc.) for 3D material deposition to print isolating/dielectric layers as a non-conductive structure that forms the body of the PCB. The electrical features (conductive elements) are preferably printed from bulk conductive metal using one or more printhead(s) that is integrated onto the same 3D printing device to enable the `hybrid printing' approach. The dimensions and the density of the electrical traces depends mainly on the printing resolution and the capability of the metal printing technology used to print the conductive metal tracks.

In terms of printing a PCB with flat top conductive metal tracks (or "traces"), irrespective of the width and the aspect ratio of the conductive metal tracks, the conductive metal tracks are, in some embodiments, preferably engraved on the first layer of the substrate that is printed. This does not necessarily indicate a (subtractive) engraving process but rather that the conductive metal traces are printed in a manner such as to appear engraved. In particular, the surface of an "engraved" conductive metal trace is preferably substantially flush with the surface of a non-conductive structure, which is formed such as to accommodate the conductive metal trace. Therefore, the invention is applicable to any type of PCB that can be printed, based on size, shape, and density of the population of the electronic components on it.

Furthermore, the invention preferably provides the possibility of elaborating the printed PCB into a 3D electronic circuit by printing subsequent layers on top of the already printed PCB. This would not be possible using technologies that require a re-flow process after printing. By directly placing the electronic components such as ICs, microchips, SMDs onto / into 3D printed structures during the 3D-printing run, and by electrically connecting them to the metal tracks forming the electrical circuit, employing the same molten metal printing method as for the printing the tracks, a fully functional electronic device with a 3D integrated electronic circuit inside can be preferably printed fully automatically. This has not been achieved by any of the prior art technologies.

In the sense of the invention, an "additive manufacturing" method is preferably a method comprising the production of objects by adding material in a step-wise manner or in increments. The incremental addition of material may preferably include the deposition of droplets of material. Additive manufacturing processes preferably use computer aided design or computer aided manufacturing to control the addition of material. Material is preferably deposited in increments, said increments preferably corresponding to droplets in a first plane and layers in a different, orthogonal plane. Droplets or other increments of the same material applied on a single plane, preferably the x-y-plane may preferably be configured to merge. Layers of the same or different material may be configured not to merge such as to create a vertical structure of predetermined height in a third dimension, although adhesion between layers may be desirable. The presence of reductive manufacturing steps in an additive manufacturing method disclosed herein is not excluded.

In the sense of the invention, an "electric circuit" is preferably all or part of a pathway through which electric current may flow. The pathway preferably comprises a conductive material. The electric circuit preferably comprises a conductive pathway which may be closed. Alternatively, the pathway may be open and may be configured for integration into further electric circuits. The electric circuit is optionally populated with electronic components such as a power source, resistors, capacitors, LEDs, microchips, sensors, such as to form an electronic circuit.

In the sense of the invention, a "build plate" is preferably a rigid structure onto which one or more materials may be printed. The surface of the "build plate" preferably determines the form of a lower surface of the electric circuit and preferably extends in the x-y-plane. Preferably, the build plate is a printer bed. Alternatively, the build plate may be a component which is not part of the printer such as a table. The build plate may also be a further component having a rigid surface in the x-y-plane onto which material is directly or indirectly printed, such as to remain adhered to the build plate or to be removed therefrom. For example, the build plate may be part of a rigid housing onto which a PCB is to be printed. Printing of the material onto the build plate may be mediated by one or more layers such as a base sheet or a previously printed layer.

In the sense of the invention, a "first printhead" is preferably a printhead configured for the selective deposition of a conductive molten metal. The first printhead preferably comprises a nozzle / multi-nozzles for this purpose and is preferably configured to withstand at least the melting temperature of the molten metal. The first printhead may optionally comprise a heater, in particular where a metal is melted *in-situ,* e.g. when provided in a solid form.

In the sense of the invention, a "metal" is preferably any substance capable of conducting electricity at a temperature of absolute zero. The metal may belong to any of the following groups: alkali, alkaline earth, transition, post-transition lanthanide, actinide. Transition metals are especially preferred. The metal may be provided as a single element or in alloy form.

The term "conductive molten metal" preferably refers to a conductive print material in a liquid state which essentially consists of a metal in liquid form. The metal is preferably the continuous phase of said liquid form, in the case that this comprises additional phases or dispersed materials. The metal may be provided in a solid form at room temperature and melted *in-situ* in order to provide for a conductive molten metal. It is equally conceivable that a metal is used which is liquid at room temperature.

Non-metallic additives may be included in the conductive molten metal. It however be preferred that the conductive molten metal be substantially free of non-metallic additives.

In preferred embodiments of the invention, the conductive molten metal when printed, comprises more than 80 wt.-% (percent per weight), preferably more than 90 wt.-%, more than 95 wt.-%, more than 99 wt.-% or more of a metal. In preferred embodiments the conductive molten metal when printed, comprises less than 20 wt.-% preferably less than 10 wt.-%, less than 5 wt.-%, less than 1 wt.-% or less of non-metallic additives.

Preferably the conductive molten metal is thus substantially different from conductive inks or silver pastes, which comprise e.g. silver in a solid (e.g. spherical) form dispersed in non-metallic additives (e.g. resins, dispersants, solvents) to allow for a printing of the conductive paste.

Advantageously by printing the conductive molten metal, essentially pure metals or alloys optimized for the desired function may thus be printed, without the introduction of substantial amounts of further non-metallic additives such as dispersants or solvents necessary in printing inks or pastes. Thereby the electrical resistance of the printed circuit may be lower and the electrical performance increased. Furthermore, the printed inks or pastes do not immediately have electrical function and require a typical sintering / post-treatment that removes the non-conductive substances and physical (merging) or chemical reactions to form conductive metal structures.

In the sense of the invention, a "second printhead" is preferably a printhead configured for the selective deposition of a non-conductive material, in particular a dielectric material, preferably a dielectric polymer material. The dielectric polymer material is preferably deposited by the second printhead in a molten liquid/gel form. Such a printhead preferably comprises a nozzle for this purpose and is preferably configured to withstand at least the melting temperature of the dielectric material but not necessarily the melting temperature of the metal provided in bulk form.

In the sense of the invention, an x-y-plane is preferably substantially parallel to the surface of the build plate onto which material is to be printed.

In the sense of the invention, a printing step, preferably comprises the targeted and selective deposition of material onto a surface, in particular onto a build plate. In particular, the deposition of material is preferably targeted in terms of the position in an x-y-plane at which the material is deposited. The deposition of the material is preferably selective in terms of the amount of material deposited, which preferably occurs as droplets, whereby at some positions no material may be deposited. Preferably, depending on the structure to be printed, a first or second printhead may be used to selectively print the dielectric material or conductive molten metal as droplets onto selected positions.

In the sense of the invention, a "conductive material" is preferably a material with a high electric conductivity and therefore a low resistance. A material is preferably considered conductive when its volume resistivity (ρ) measured at 20 °C is less than 1 × 10⁻⁴ Ω·m, more preferably less than 1 × 10⁻⁶ Ω·m, even more preferably less than 1 × 10⁻⁷ Ω·m, which includes the vast majority of metallic substances.

In the sense of the invention, a "conductive element" is preferably a printed feature configured to conduct electricity within a circuit and comprising a conductive material. The conductive element may have substantially any size or form and preferably has a resistivity measured at 20 °C of not more than 1 × 10⁻⁴ Ω·m, which may preferably be determined based on the cross section of a printed droplet.

In the sense of the invention, a "dielectric material" is preferably a material with a low electric conductivity such that substantially no electrical current may flow through the material. At the same time, the dielectric material can preferably support electrostatic fields, that is, the material may preferably be polarized by the application of an electrical field. Preferably, the force between two electric charges in a dielectric medium (the permittivity) is less than it would be in a vacuum, while the quantity of energy stored in an electric field per unit volume of a dielectric medium is greater.

The ability of a dielectric material to store an electrostatic field is preferably represented by its relative permittivity (εᵣ), which is a measure of its permittivity relative to a vacuum. A dielectric material in the sense of the invention preferably has a relative permittivity greater than 1. The relative permittivity is preferably also lower than 100, more preferably lower than 50, even more preferably lower than 10.

The dielectric material may also be characterized by its volume resistivity (ρ), wherein ρ = R × (A/L). The dielectric material preferably has a volume resistivity measured at 20 °C of at least 0.1 × 10¹⁵ Ω·cm, more preferably at least 1 × 10¹⁵ Ω·cm, even more preferably at least 5 × 10¹⁵ Ω·cm.

In the sense of the invention, a PCB is described as being "two-dimensional" or "2D" when it comprises only a single functional layer, for example conductive elements in a single plane surrounded by non-conductive material in the same plane, and has a substantially constant overall thickness of less than 3 mm, more preferably less than 1 mm. Such a PCB may be flexible, being configured for example as a polymer foil which may be laminated onto another structure.

In the sense of the invention, a PCB is described as being "two-and-a-half-dimensional" or "2.5D" when it comprises one or more functional layers, for example conductive elements on one or both of its faces, and has a substantially varying thickness and/or an overall thickness greater than 0.4 mm, preferably greater than 1 mm or greater than 2 mm. For instance, in preferred embodiments a 2.5D PCB may comprise 10 layers and have a thickness of 2.4 mm. Such a 2.5D PCB has a higher level of complexity compared to a 2D PCB as the varying layer thicknesses or the thicker structure may present built-in mechanical features and/or the multiple functional layers may reduce the need for the PCB to built up in parts on different devices.

In the sense of the invention, a PCB is described as being "three-dimensional" or 3D when it comprises multiple functional layers, such as different layers of conductive elements enclosed between layers of non-conductive material and has a thickness greater than 3 mm, more preferably greater than 5 mm. A 3D PCB may include a complete product, including a housing, or a standardized port to connect the PCB to a power source.

In the sense of the invention, a "droplet" is preferably a discrete unit of liquid or gel material surrounded by an interface to the environment. Preferably, the droplet is at least momentarily free of contact to the relevant printhead and/or to a surface onto which it is deposited, such that the droplet deposition is preferably a non-contact deposition technique. A droplet preferably has a maximum diameter of 1 mm, preferably 500 µm when measured in any direction.

In a preferred embodiment, the method comprises providing the conductive metal to the first printhead in bulk form, preferably as a solid at room temperature. Conductive elements printed from a conductive molten metal provided in bulk form have much lower resistance and higher electrical performance compared to the conductive inks of the prior art. Provision of the molten metal in bulk solid form is preferably accompanied by *in-situ* melting of the metal, e.g. using a heater in the first printhead. This allows for safe and compact storage and provision of the conductive metal whilst also adjusting the temperature and viscosity of the metal being deposited. Control over these parameters further allows for adjustment of droplet size and droplet solidification between the first printhead and the surface onto which the molten metal droplets are deposited, such that these merge into one another without modifying the geometric form of lower layers.

In the sense of the invention, "bulk form" preferably refers to the presence of a material in sufficiently relatively large and continuous units such as to be seen, touched or weighed. In particular, a solid material is considered present in bulk form when its smallest unit, such as a wire, chip, granule, briquette, bead or the like, has a minimum dimension of at least 50 µm. A liquid material may also be considered present in bulk form when it is of sufficient volume and/or forms a continuous phase of a suspension or solution. A material provided in bulk form is therefore preferably not provided in the form of nanoparticles or as a highly dispersed non-continuous phase in a suspension. A conductive metal provided in bulk form is thus distinct from a conductive ink containing dispersed metallic nanoparticles in a continuous phase.

A metal provided in "bulk form" is preferably provided in a solid or liquid state and preferably comprises a pure metallic material (e.g. tin) or its alloy (e.g. a tin silver copper alloy). Preferably substantially no other substances are present in the bulk form which are not part of the metallic material or alloy. In addition to the aforementioned forms, such a metal in bulk form may be provided as a powder. The metal provided in bulk form is preferably substantially free of liquid additives such as solvents or carriers. Where such liquid additives are present, they preferably do not serve as a continuous phase for suspending metal particles.

In a preferred embodiment of the invention, the method comprises the steps of
a.) printing a non-conductive structure using the second printhead of the printing device; and printing conductive elements onto the non-conductive structure using the first printhead of the printing device or
b.) printing conductive elements using the first printhead and printing the non-conductive structure on top of the conductive elements using the second printhead of the printing device.

The non-conductive structure and conductive elements may be printed over one another in any order. In alternative embodiments disclosed herein, the non-conductive structure and conductive elements may be printed side-by-side simultaneously or in any sequence.

By printing the conductive elements onto the non-conductive structure, these may be applied onto a flat surface or inserted into pre-formed channels or recesses of the non-conductive structure. This sequence may be used to build an electronic circuit onto a non-conductive layer which may form part of a multi-layered or three-dimensional product. The conductive elements may thus be added onto an existing circuit or part thereof to form an additional layer of a circuit. Additionally, printing the conductive elements onto the non-conductive structure allows for additional components to be provided between the conductive elements and the non-conductive structure and stabilized by the conductive elements.

Step b.) presents an alternative to known methods of embedding conductive elements in a PCB and produces the effect of "engraving" said conductive elements into the non-conductive structure. This preferably means that the conductive elements are provided exposed at the surface of the PCB, such that their exposed surface is substantially level with the exposed surface of the non-conductive material, whereby part of the conductive material is surrounded and fixed by the non-conductive material. However, the dusts and waste produced by subtractive engraving., i.e. removing material from the surface of a non-conductive structure, are avoided. This embodiment is of great interest since it allows the creation of two-sided PCBs and multi-layer PCBs when coupled with other embodiments.

By printing the non-conductive structure onto the conductive elements, a multi-layered structure may be built up further, for example, where step b) is carried out after step a). In such a case, the non-conductive structure may form the cover of the same or a further PCB. Step b) may also be carried out independently of step a) for example where the conductive elements printed are configured to form part of the surface of a printed circuit board. Printing the conductive elements first allows these to solidify from the molten state before the non-conductive structure is printed onto and optionally adjacent to these. The conductive material may have a melting point higher than that of the non-conductive material, such that said non-conductive material may remain soft or liquid when applied onto the solid conductive elements, without remelting or reforming these elements. The non-conductive material may thus fill gaps between the conductive elements. The non-conductive structure and the conductive elements may also take on the surface quality or texture of the surface onto which it is printed, such that these preferably have a smooth finish. The shape and spread of the deposited conductive material could also be controlled by the surface onto which it is printed depending on the wetting behavior of the conductive material on said surface.

In a further preferred embodiment of the invention, the method comprises melting a bulk metal using a heater to print the conductive elements. The heater is preferably located in the printing device, especially preferably in the first printhead. Preferably, the heater is configured as a resistive or inductive coil substantially surrounding a reservoir for storing the raw material for the conductive molten metal in the printhead. In preferred embodiments, the raw material, e.g. as a metal in bulk form, may be provided to the printing device as a solid, in particular as a wire or as granules, and may be melted *in-situ.* The heater is preferably configured to heat the raw material to a temperature equal to or above its melting point, such that the contents of the reservoir are brought to a temperature between 200 und 2000°C, more preferably between 200° and 1000°C, even more preferably between 300 - 800 °C. The preferred heating temperature depends on the melting properties of the metal or alloy used. Preferably the heater reaches a maximum temperature of 450 °C, which was found to provide a high level of machine durability and the ability to process a variety of metallic materials. Higher heater temperatures could however be reached by selecting an appropriate material for the reservoir and/or for any heating elements of the printing device.

The bulk metal provided as a solid can be dosed precisely, e.g. by length of wire, by mass of granules or by number of droplets, and can be melted *in-situ* to control its temperature and rheology. This allows for control of the deposition process, such as to create uniform droplets and a substantially uniform cross section of conductive elements, in particular of conductive traces. Advantageously, no dangerous or toxic dusts are emitted by the first printhead when the molten metal is melted from a bulk metal. When melting is carried out *in-situ,* the risk of leaks upstream of the first printhead is eliminated. This may be done using an inert gas, preferably nitrogen. Use of bulk metal, in particular in solid form, advantageously allows for the use of a much wider range of materials for the conductive elements and the non-conductive structures. Materials with a large difference in melting points may be selected for the conductive elements and the non-conductive structures. In this manner, the non-conductive structure may remain in a liquid or gel form during printing, without causing unwanted melting of the conductive elements. The forms and distribution of the already-printed conductive elements is thus not affected by the addition of further layers of non-conductive materials. Furthermore, bulk metals of different melting temperatures may be used for different conductive elements. For example, a bulk metal used for soldering may have a relatively low melting temperature such as not to re-flow the metal contained in an adjacent conductive trace and/or electronic component.

In a further preferred embodiment of the invention, the method comprises melting a metal, in particular melting metallic particles during or after deposition, using a remote heater. Such a remote heater is preferably not in direct contact with the metallic particles. Preferably, one or more lasers may be used as the remote heater. This may increase the temperature of the metallic particles such as to melt these into one another to form continuous conductive elements.

In a further preferred embodiment of the invention, the conductive elements include conductive traces, conductive pads, conductive soldering and/or conductive interconnects. Such conductive elements may be adapted for the flow of electrical current through a circuit of any degree of complexity. The conductive elements may be dimensioned such as to provide a suitable electrical resistance.

The conductive traces preferably comprise a substantially uniform cross section which is multiple times smaller than their length. For example, the diameter or width of a conductive trace may be less than 1000 µm, preferably less than 500 µm, less than 100 µm or even less than 10 µm, while its length may be of several millimeters, e.g. more than 1 mm, more than 3 mm or more than 10 mm.

Conductive traces are especially preferred for connecting electronic features with one another. The electronic features for which the conductive traces are configured to connect may include nodes, junctions, SMDs (surface mounted devices) and/or additional conductive elements. For example, conductive traces may be printed to connect conductive pads with one another. In further preferred embodiments of the invention, the conductive traces are used to create passive elements in an electric circuit, such as capacitors or resistors. These may preferably be built in three dimensions, e.g. for the building of a three-dimensional capacitor. Furthermore, when conductive material is printed before non-conductive material, this presents an opportunity to print RF structures with a smooth metal surface finish, preferably having a surface roughness less than 300 nm. The smoothness of the surface finish may be improved by providing a suitable build plate (print bed) with a suitable surface finish.

Conductive pads are especially preferred for mounting SMDs onto the PCB. These may allow the SMD to be provided with current from the conductive elements. Conductive soldering and/or conductive interconnects may further mechanically stabilize and/or connect SMDs to the conductive elements, such that these may be provided with current during use of the PCB. Additionally, the conductive elements may also act as the electrical communication pathway, i.e. for delivery of information and control signals.

By printing these conductive elements from molten metal, they can be of sufficient diameter, width and/or thickness such as to provide a high current to the electronic features they connect. This significantly improves the performance of printed PCBs over the prior art, in which thin layers of high-resistance conductive inks are used. Further, the conductive elements may be formed with precise and uniform dimensions when printed on the same printing device as the non-conductive structure. This is because similar layer thicknesses may be achieved for both conductive and non-conductive materials and both materials may be built up without moving the PCB.

In a further preferred embodiment of the invention, the method comprises melting a dielectric material using a heater to print the non-conductive structure. The heater is preferably located in the printing device, especially preferably in the second printhead. Preferably, the heater is configured to melt a filament, powder and/or granulate of a dielectric material according to a printing method. This preferably includes fused filament deposition (FFF). The dielectric material may be provided in reinforced form, such that it includes for example, reinforcing fiber(s). Preferably, the melting of the dielectric material includes heating said material using a heater to a temperature at or above its melting point, but preferably below the melting point(s) of any reinforcing fiber(s). The heater thus preferably heats the dielectric material to a temperature between 50 °C - 600 °C, more preferably between 60 - 300 °C, more preferably to between 100 - 250 °C. The majority of suitable dielectric materials require a minimum nozzle temperature of at least 160 °C.

*In-situ* melting of the dielectric material permits fine dosing of the material. It further allows the material to be deposited by non-contact methods such as in the form of droplets, analogous to the molten metal, which further aids uniformity and layer thickness control. Furthermore, melting the dielectric material during or upon deposition allows for a good fit between the conductive and non-conductive materials in the PCB.

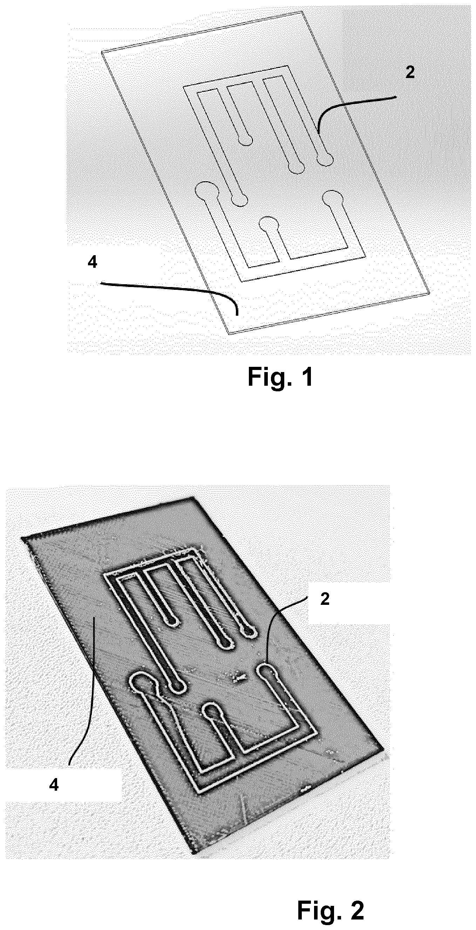

In a further preferred embodiment of the invention, the method further comprises the steps of providing a base sheet on the build plate before printing the conductive elements onto the base sheet and subsequently printing the non-conductive structure onto the conductive elements such as to enclose the conductive elements between the non-conductive structure and the base sheet and optionally removing the base sheet after printing of the non-conductive structure is complete. This is explained further herein with reference to Figs. 1 - 4.

In this manner, the conductive elements may be provided at the surface of the PCB such as to be exposed. At the same time, the non-conductive structure may be sufficiently thick such as to provide the PCB with adequate mechanical properties. In some embodiments, the non-conductive structure may be provided as a flexible layer in combination with flexible conductive elements, formed e.g. from SAC305, such as to create a flexible PCB. Enclosing the conductive elements between the non-conductive structure and the base sheet provides mechanical stability and electrical isolation. Further, both the conductive elements and the non-conductive structure can take on the surface quality of the base sheet or the surface onto which they are printed, which is preferably smooth. As such, the produced PCB may have a very smooth surface, reducing the risk of damage due to wear and tear. For example, the conductive traces need not protrude out of the surface of the PCB and are therefore less likely to be accidentally scraped off. Furthermore, one or more conductive elements may be made perfectly flush with the non-conductive structure without the polishing or other subtractive methods of the prior art. This improves the stability of the PCB against corrosion and improves the electrical insulation of the conductive elements.

The base sheet is preferably a solid material layer configured to separate the printed materials from the build plate and/or to provide a surface quality to the printed electronic circuit. Separation of the printed materials from the build plate preferably prevents unwanted adhesion of the material to the build plate. The adhesion of the printed materials to the base sheet is preferably also limited, such that the base sheet may be removed from the solidified printed circuit board without damage. The material of the base sheet and optionally any surface treatment of the base sheet are preferably selected accordingly. While the base sheet is preferably smooth, it may alternatively be provided with a texture, e.g. for use as a watermark. It may be preferable for the base sheet to be a single-use component, such as to maintain high smoothness and prevent contamination.

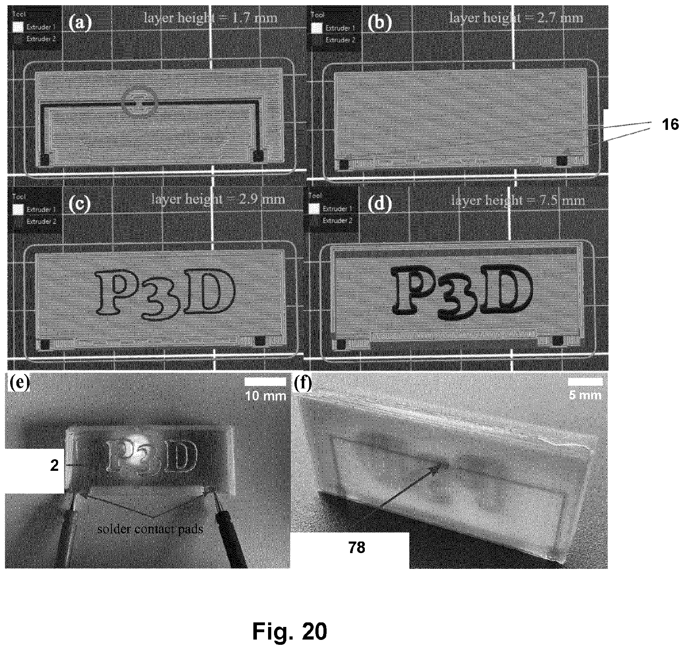

The use of the base sheet is optional and may be omitted. The conductive elements may be printed directly onto the build plate, in particular where these and the non-conductive structure do not adhere to said build plate. The non-conductive structure may be subsequently printed onto the conductive elements such as to enclose the conductive elements between the non-conductive structure and the build plate. The printed circuit board comprising the non-conductive structure and the conductive elements may be peeled or otherwise removed from the build plate after this solidifies. In this manner, the use of consumable materials such as rolls of base sheet may be omitted, making the manufacturing process more environmentally friendly. This is illustrated using suitable materials in Fig. 20 and is explained further in the detailed description.

In a further preferred embodiment of the invention, the build plate of the printer, a build plate and/or a base sheet is preheated before printing of the non-conductive structure and/or the conductive elements. Preferably, the temperature to which the base sheet is heated is lower than the melting point of the molten metal, such that the metal still solidifies upon contact with the base sheet. It was surprisingly found that heating the base sheet could further improve the surface quality of the printed circuit board, e.g. by slowing the solidification of the printed material and preventing crystallization due to rapid freezing. Pre-heating of the base sheet additionally improves the flow of non-conductive material when this is printed in a liquid or gel state onto the conductive elements, such as to produce a continuous structure. In a preferred embodiment, the base sheet is heated to a temperature between 40 - 250 °C, preferably 40 - 100 °C, even more preferably 40 - 70 °C.

In a further preferred embodiment of the invention, the method further comprises a step of placing electronic components at predetermined locations on the non-conductive structure printed using the second printhead and/or the conductive elements, wherein the placing occurs manually or by means of a pick-and-place robot head, the pick-and-place robot head preferably forming a part of the printing device, wherein optionally an adhesive is applied to the electronic components or at the predetermined locations before placing the electronic components at the predetermined locations. The electronic components may preferably be surface mounted devices (SMDs). Nonlimiting examples of preferred electronic components include transistors, diodes, resistors, capacitors, integrated circuits, power supplies, LEDs, sensors etc. The adhesive is preferably applied by an additional printhead.

A fully functioning PCB may thus be manufactured in a single station - namely on the build plate - without necessarily moving the printed non-conductive structure. Thus, the electronic components may be positioned very precisely thereon. Furthermore, placement of the electronic components may occur during or between printing steps, such that one or more materials onto which the electronic components are placed or which are printed onto the electronic components are still in a liquid or deformable state. This allows for high mechanical stability of the electronic components on the PCB after solidification.

In a further preferred embodiment of the invention, the method further comprises using the shrinkage of one or more printed materials to create apertures, particularly slots, for the placement of SMDs. Said apertures are preferably provided in the non-conductive structure. It was surprisingly found that the shrinkage of a variety of printed dielectric materials provides cavities which are especially suited to encapsulating an SMD or a part thereof. Furthermore, the compact packing of SMDs into the dielectric material could provide enough thermal energy to the conductive material when connecting the SMD to the trace printed on the dielectric substrate.

It is especially beneficial to place the electronic components at predetermined locations on the non-conductive structure and/or the conductive elements as an intermediate step in the manufacture of the PCB when the PCB has a degree of complexity which would make the placement of such components after complete manufacturing of the non-conductive structure and/or conductive elements difficult. It is thus advantageous to add the electronic components before adding further complexity to the circuit structure. This increases the design freedom of the PCB. Further, when additional layers of material are to be added to the PCB, it is advantageous for lower layers to be populated with electronic components before further layers are printed on top. The further layers can then advantageously be printed using the same printing device.

In a further preferred embodiment of the invention, the non-conductive structure is provided with vias, in particular by suitable configuration of the printing process. The vias may be internally coated using conductive material and used for populating the PCB with electronic components from both sides and/or from further layers. The vias preferably represent vertical electrical connections which run substantially orthogonally to conductive elements arranged in x-y-planes. Preferably these vias are not provided by drilling or another subtractive process but by configuring the printing method such that material is omitted in the cavity which is to function as the via. Internal coating of the via is preferably also achieved by selective deposition of the conductive material at positions corresponding to the inner surface of the via. In this manner, waste and dust may be avoided whilst a high complexity of the PCB may be achieved. The vias further allow multiple layers or wafers of a PCB to be electrically connected with one another, supporting the manufacture of complex and three-dimensional PCBs.

In a further preferred embodiment of the invention, at least a portion of the conductive elements is printed from a molten metal onto a non-conductive structure comprising positioned electronic components such as to solder and/or electrically contact and/or mechanically stabilize the electronic components on the electronic circuit.

Soldering can thus be carried out in a precise manner and at the same workstation. It was also surprisingly found that soldering could be carried out with a precise dosage of molten metal, preferably determined by the droplet size emitted by the first printhead, and in a very uniform manner, avoiding the large solder beads which can often occur in the known soldering techniques. A further advantage of this preferred embodiment is that post-processing of the printed PCB may be reduced or eliminated, further shortening the turnaround times for producing fully populated and functional PCBs. Preferably, the temperature of the build plate and/or base sheet which supports the PCB during soldering is adjusted to effect rapid solidification of the solder material.

In a further preferred embodiment of the invention, printing the non-conductive structure is carried out such as to form grooves and/or recesses on a surface of the non-conductive structure, the grooves and/or recesses being configured to accommodate conductive elements, such as conductive traces, and/or electronic components, and printing the conductive elements is preferably at least partially carried out such as to insert the conductive elements into the grooves and/or recesses.

This technique preferably allows the conductive elements to be printed such that their exposed (upper) surface is flush with the exposed (upper) surface of the non-conductive structure. At the same time, the conductive elements are exposed and can be populated with electronic components, e.g. using a pick-and-place robot head, without necessarily moving the printed device and/or turning it around to expose the conductive elements. This technique also provides further flexibility in the rheological properties of the molten metal used to form the conductive elements. For example, a conductive molten metal may be printed into grooves and solidified by lowering the temperature. It may also be preferred that a metal which is liquid at room temperature may be used to fill the grooves without unwanted melting of the non-conductive material. The metal may then be cured or otherwise solidified. As a further alternative, it is preferred that sufficient thermal energy is dissipated from the molten metal during deposition, such that this may adhere to the non-conductive material of the grooves without melting it. Melting of the non-conductive material is preferably avoided by depositing the molten metal as droplets in a non-contact deposition method and adjusting the size and trajectory of the droplets such that these only have enough thermal energy to adhere upon reaching the non-conductive material but not to deform the shape of grooves on the macro scale.

In a further preferred embodiment of the invention, printing the non-conductive structure includes the addition of mechanical features such as a housing, a cover, mounting holes, hinges, snap locks and the like. In this manner, a complete device, including both electronic and mechanical aspects, may be rapidly produced in a single station.

In a further preferred embodiment of the invention, the method comprises repeating the steps of printing the conductive elements from the conductive molten metal using the first printhead and printing the non-conductive structure using the second printhead of the printing device such as to enclose one or more layers of conductive elements between any number of non-conductive structures, wherein optionally electronic components are placed at predetermined positions between consecutive non-conductive structures.

It has thus far not been considered practical to produce a printed circuit board using multiple layers of conductive elements and non-conductive structures. This is due to the known techniques causing an unwanted re-flow (melting and deformation) of lower layers, at least partially due to the thinness of the conductive inks and the closeness of the melting points of materials used. The preferred embodiment of layering the conductive elements and/or non-conductive structures instead allows for complex three-dimensional structures to be produced precisely and efficiently using a single printing device. By layering the materials over one another, complex electronic and mechanical structures may be formed. The layers may be configured such as to fully enclose the conductive elements in a non-conductive structure, increasing the lifetime of the circuit.

In a further preferred embodiment of the invention, printing of the non-conductive structure occurs using a dielectric material in a molten state by any one of the following techniques: fused filament fabrication, direct material jetting or a combination thereof, wherein fused filament fabrication (FFF) is preferred. These techniques have been found to provide good resolution and feature size for the non-conductive structure and are especially suitable for printing the non-conductive structure and the conductive elements with a suitable layer thickness and uniformity. These techniques also provided a good surface quality. The especially preferable methods such as fused filament fabrication (FFF) could be applied by extruding filaments of defined diameter, such as to control the dimensions and form of the printed parts.

In a further preferred embodiment of the invention, the method is so configured that the layer thickness of the printed non-conductive material is substantially identical to the layer thickness of the printed conductive material. This may be achieved by adjusting the exit diameter of a nozzle of the first and second printheads, taking account of the rheological properties of each of the materials used, such that the printed feature size of both materials is substantially identical. The similarity between the layer thicknesses of both materials allows for a particular smooth and mechanically stable PCBs to be printed with fewer production steps. At the same time, conductive traces may be relatively thick and may have a low resistance.

In a further preferred embodiment of the invention, the non-conductive material is a dielectric material, preferably selected from the group comprising: PLA, PET, PTFE, PP, PMMA, nylon, Polyimide or Polycarbonate, wherein PET-g (polyethylene terephthalate-glucose) is especially preferred.

In a further preferred embodiment of the invention, the molten metal is selected from the group comprising: silver, copper alloys, zin alloys, aluminum alloys or tin alloys, wherein SAC305 (Sn96.5Ag3Cu0.5) is especially preferred due to it being the primary lead-free solder for attaching electronic devices to printed circuit boards [P47], and having a melting point of 217 °C, which is sufficiently distanced from the melting point of preferred dielectric polymers. Furthermore, using molten metal, with a melting point of more than 200 °C or more, such as SAC305, the molten metal can be deposited as metallic droplets with sufficient thermal energy to bond with a non-conductive polymeric material and this can be done in an economic manner. The melting temperature of the metal is preferably between 200 und 500°C, more preferably between 200° and 400°C, even more preferably between 300 - 350 °C. Preferably the molten metal has a melting point not higher than 450 °C, such as to be meltable and dispensable by economic and durable means. It was surprisingly found that these materials could be printed with a uniform droplet size while providing a low electrical resistance.

In a particularly preferred embodiment of the invention, the molten metal is SAC305 (Sn96.5Ag3Cu0.5) and the dielectric material is polyethylene terephthalate-glucose (PET-g). This combination provided sufficiently different melting points such that the application of molten PET-g onto conductive elements printed from SAC305 did not melt the conductive elements, which retained their shape as originally printed.

In further preferred embodiments of the invention, the melting point of the metal (or metal alloy) used for the conductive molten metal is at least 20 °C, preferably at least 50 °C, more preferably at least 100 °C or more higher than a melting point of the non-conductive dielectric material to be printed. This ensures that when printing non-conductive structures using the dielectric material on top of the conductive elements a risk of partial melting or deterioration of the conductive elements may be minimized.

In further preferred embodiments of the invention, the melting point of the metal (or metal alloy) used for the conductive molten metal is not more than 2000 °C, preferably not more than 1000 °C higher than a melting point of the non-conductive dielectric material to be printed. This minimizes the risk of deforming the non-conductive elements when printing conductive elements using the conductive molten metal droplets, as sufficient thermal energy may be more easily dissipated from the molten metal droplets whilst it is being deposited. As explained further herein, this risk is further minimized by adjusting the build plate temperature, local air temperature and droplet size such as to encourage a lowering of the temperature of the deposited metal before it reaches the existing layers of the PCB and to encourage rapid solidification.

In further preferred embodiments of the invention, the melting point of the metal (or metal alloy) used for the conductive molten metal is between 20 °C to 250 °C preferably 50° to 150 °C higher than a melting point or a glass transition temperature of the non-conductive dielectric material to be printed. With these conditions advantageously multilayered structures may be provided, in which the subsequent printing of a conductive element on top of a non-conductive structure or in the reverse order without a risk of interfering with the functional integrity of the already printed structure.

A person skilled in the art may choose the metal and/or dielectric material accordingly.

In a further preferred embodiment of the invention, printing the non-conductive structure comprises a step of solidification of a molten dielectric material, said solidification step preferably comprising a thermal phase change and/or curing by means of thermal and/or ultraviolet radiation. Other means may also be used to effect the solidification such as a high intensity light, e.g. a laser. Electromagnetic radiation of other regions of the spectrum may also be used at suitable intensities to solidify the material. The produced PCB is thus fully robust and unsusceptible to unwanted deformation.

In a further preferred embodiment of the invention, printing the conductive elements occurs by any one of the following techniques: drop-on-demand deposition, continuous droplet generation (e.g. continuous inkjet), extrusion, deposition of a molten metal jet or a combination thereof, wherein drop-on-demand deposition is preferred. These techniques were found especially suitable for the printing of a molten metal with a high degree of precision, uniformity and a high resolution. In particular, drop-on-demand deposition allowed for fine tuning of the temperature profile of the molten metal between the printhead and the build plate or PCB, such that adjacent droplets of the same layer could merge with one another without reflowing lower layers. For some soldering applications, the use of a continuous inkjet was also preferred, for providing a continuous electrical connection between parts.

In a further preferred embodiment of the invention, printing the conductive elements comprises a step of solidification of the conductive elements from a molten state, solidification preferably occurring by ensuring the temperature of a surface onto which the conductive elements are printed is at a lower temperature than a melting point of the bulk metal, preferably by at least 20°C, more preferably at least 50°C, 100°C or more. Preferably, for a bulk metal having a melting temperature between 200 - 250 °C, this is heated in the printing device to a temperature between 200 - 500°C, preferably 250° - 400°C, even more preferably 300 - 350 °C. The solidification of the conductive elements provided for a stable structure, whereby the form of the conductive elements could be maintained during further steps such as layering additional materials onto the conductive elements, peeling a base sheet from the PCB and/or placing and soldering electronic components.

In a further preferred embodiment of the invention, printing the conductive elements comprises a step of releasing a molten metal droplet from the first printhead to a surface, wherein a droplet diameter and/or a distance from a nozzle of the first printhead to the surface is selected such that the molten metal droplet is at a temperature higher than its melting point at the nozzle and is at a temperature substantially equal to or lower than its melting point upon reaching the surface, for instance by at least 10°C, 20°C or more.

This allows the droplet to be initially in a liquid state upon deposition. Such a state allowed for very round and uniform discrete droplets to be formed by surface tension. Upon reaching the surface onto which they are deposited, e.g. the build plate, a base sheet, a non-conductive structure or a lower layer of conductive material, the droplets may be momentarily in a liquid or gel form which allows adjacent droplets to merge before rapidly solidifying, such as to form a smooth, solid structure, which is not deformed by further process steps.

The droplet size is preferably adjusted to achieve this, in particular using known methods of adjusting the pressure and/or flow rate at the nozzle and the exit diameter of said nozzle of the first printhead. Preferably, the nozzle has an exit diameter between 40 µm - 700 µm, more preferably between 70 - 500 µm, even more preferably between 80 - 300 µm. The conductive elements formed in this manner may have a high resolution and uniformity due to the uniform droplet size. Merging of the droplets placed at precise position with precise droplet spacing also allows for conductive traces to have a uniform cross section and therefore a uniform electrical resistance, improving the electrical performance.

In a further preferred embodiment of the invention, printing the conductive elements comprises a step of releasing a molten metal droplet from the first printhead to a surface, wherein a cooling mechanism, preferably based on liquid nitrogen, is provided at the first printhead for actively cooling the molten metal droplet on a trajectory between the first printhead and the surface. For instance, by means of a cooling mechanism it may be ensured that the droplet is cools during the trajectory between the first printhead and the surface by at least 20°C, 50°C, 100°C or more.

Preferably, liquid nitrogen is supplied to a cooling device in order to accelerate cooling of the molten metal droplet. This is especially advantageous where the temperature of the molten metal in the first printhead is so high that the droplet would not instantly solidify upon reaching the surface onto which it is deposited. With active cooling, a wider range of metals with different melting temperatures may be used. Additionally, reflowing of existing layers of material of the PCB may be avoided, especially where these are of the same material or a material with a similar melting temperature. It is thus possible to manufacture PCBs of a high complexity and mechanical stability, using multiple layers and in three dimensions.

In a further preferred embodiment of the invention, the conductive elements are printed by drop-on-demand deposition wherein a droplet-to-droplet spacing is smaller than an average droplet diameter and is configured such that consecutive droplets merge. Preferably, the average droplet-to-droplet spacing is between 10% and 90%, preferably between 20% and 80%, between 30 % and 60 %, between 40 % and 60 %, most preferably at around 50 % of the average droplet diameter. The average droplet diameter is preferably between. 50 - 600 µm, more preferably 100 - 500 µm, especially preferably 250 - 300 µm. Preferably, the droplet-to-droplet spacing is 20 - 500 µm, more preferably 80 - 250 µm, especially preferably 100 - 200 µm. It was surprisingly found that this droplet merging improved the mechanical strength and electrical performance of the conductive elements. The preferred droplet diameter and droplet-to-droplet spacing also achieved an optimized cooling profile from the first printhead to the surface onto which the droplets are deposited as well as rapid merging and solidification of the droplets.

In a further preferred embodiment of the invention, the method comprises the manufacture of three-dimensional structures with embedded electrical features. Embedding the electrical features prevents damage or corrosion to these and improves the electrical isolation. It also allows for complete electronic products to be produced in one station. The method preferably comprises selective deposition of at least one dielectric material. Further, the method preferably comprises solidification of the dielectric material by thermal phase change, UV curing or other suitable means.

In a further preferred embodiment of the invention, the method comprises the creation of holes, void volumes or other cavities during the manufacture of the non-conductive structure. Such cavities may advantageously save material, reduce the weight of the PCB and increase manufacturing speed.

Preferably, the method comprises selective deposition of at least one molten metal in liquid state to form conductive tracks on top of the build plate and/or the already printed previous layer. The conductive metal material can be printed/dispensed in form of droplets or jet or other forms.

Preferably, the solidification of the molten metal occurs by thermal phase change by maintaining the build plate and/or the already printed previous layer at a temperature below the solidification point of the metal material. A three-dimensional structure may be completely built up by repetition of the selective deposition of the dielectric material and the at least one molten metal.

The conductive material deposition method preferably employs a pneumatically driven printhead such as the StarJet technology described in more detail herein below.

The dielectric material deposition method is preferably a direct polymer deposition method that supplies a thermoplastic material in its molten state such as fused filament deposition (FFF) or a molten polymer jetting method.

The temperature of the molten metal printhead is preferably higher than the melting temperature of the metal. The temperature of the non-conductive material printhead is preferably lower than the solidification temperature of the metal. Direct jetting of metal droplets or jets is preferably applied to create electrically conductive connections between the electrodes of electronic components and/or previously printed metal tracks.

The additive manufacturing of fully printed electrical circuits including the populated electronic components via a simple fully automated device preferably eliminates the need for a centralized production of PCBs in a factory with various set-ups for sequential processing like etching, resistor stripping, hole drilling, soldering etc. to name just a few. Moreover, it highly reduces the manufacturing complexity and subsequent manufacturing process steps.

First printing the conductive metal tracks on the build plate and then covering them with non-conductive material, preferably provides a fully printed PCB with smooth top surfaces for both conductive metal tracks and non-conductive structures that can be easily processed with conventional downstream soldering technology (e.g. SMT or any other).

Preferably, no post-treatment for increasing the conductivity of metal tracks needed. High conductivity of metal tracks is granted by use of bulk metal for deposition, and the high aspect ratio of printed conductive metal tracks.

Printing of bulk metal such as solder preferably enables the direct soldering of the ICs, SMDs and other electronic components as part of the fully automatic hybrid 3D printing process. The direct soldering of electronic components with a hot liquid metal jet is highly novel and innovative, as well as it highly reducing the manufacturing processes and increasing compatibility and flexibility of populating electronic components within / on the surface of 3D printed PCBs.

The invention preferably further provides user-specific PCB design flexibility, material freedom for the PCB board and the possibility to fabricate an entire end-user electronics device. The electronics device can be grown over the printed PCB board. Material for the electronic device can be different from the material used for printing PCB board.

In a further preferred embodiment of the invention, the printing is carried out based on CAD data supplied to the printing device and/or to a processor in communication with the printing device. The CAD data may be adapted for direct printing of 3D electronics or multi-layer PCBs, optionally including a 3D design of mechanical structures with embedded 3D electric circuits with/without electronic components. This may include several layers of metal and/or non-conductive structures. The CAD may be processed by a processor to provide individual layer designs, which may also be split into designs for each material type.

As an Example: First, the CAD design file of the 3D object will preferably be sliced into numerous 2D layers in a horizontal direction. The series of 2D designs will be printed layer-by-layer using appropriate infill patterns, like usually done in 3D printing. For each layer, if applicable, the design will be split into 1. A design for non-conductive material and 2. A design for the conductive material, and 3. a design for placing the electronic components. These designs preferably include information regarding at which points within the specific layer the non-conductive material, the conductive material or an electronic component (e.g. SMD device) should be placed. All printing and/or placing processes will be operated in sequence before moving to the next layer. An exemplary sequence is 1. printing the non-conductive material, 2. placing the electronic components if applicable, and 3. printing conductive material if applicable. However, the process is not restricted to this specific sequence and also other sequences might be used, if considered as beneficial.

The processes according to this presented invention preferably require no post processing of the printed conductive metal tracks, which is one major improvement over the state of the art. The absence of any post processing by heat treatment and the use of bulk material for the conductive as well as non-conductive parts of the printed object enables a much larger choice of materials for the electrical connections and the isolating layers than with existing technologies. The process can preferably work on any additive manufacturing set-up that can lay down the conductive metal tracks and isolating layers in molten / liquid state (that solidify right after printing of the line / layer). Without losing this general claim, and just for the purpose of clarity, several possible embodiments and application examples have been described further that present a neat coherence of conductive metal tracks and insulating material in the form of 3D printed PCB and other electronic circuits.

As a mere example, the method of the invention can be used for rapid prototyping of printed circuit boards (PCB). Such a method preferably comprises the following steps:
1) Deposit conductive material onto a flat surface to form at least one layer of conductive metal tracks;
2) Deposit dielectric material via contact or semi-contact methods to cover the metal tracks to form a supportive dielectric structure; and
3) After solidification of the dielectric material, the printed PCB is removed from the surface.

Preferably, solidification of the conductive metal tracks preferably occurs between step 1) and 2).

The resulting printed circuit board preferably features a flat and smooth surface with electrically conductive wirings and pads on the top surface. This can be populated with electronic components with conventional soldering methods (e.g. SMT) like any other standard PCB known in the art.

The printed circuit board may have multiple layers of conductive features, 3D freeform wirings, vertical VIAs and embedded electronic components.

In a second aspect, the invention relates to a printing device for the additive manufacturing of an electronic circuit by a method according to any one of the preceding claims. The printing device comprises a build plate; a first printhead configured for printing conductive elements from a conductive molten metal; and a second printhead configured for printing a non-conductive structure from a dielectric material.

Preferably, the printing device further comprises a heater configured to melt a conductive metal provided in bulk form. Preferably, the first printhead is configured for printing conductive elements from a conductive molten metal provided by the heater. Preferably, the printer comprises means for moving the first printhead and the second printhead in an x-y-plane relative to the build plate. The printhead and the second printhead may be moveable simultaneously and/or independently of one another. Additionally or alternatively, the printer comprises means for moving the build plate in an x-y-plane relative to the first printhead and the second printhead. Preferably, the first printhead, second printhead and/or the build plate are also moveable in the z-plane relative to one another. This is especially advantageous for producing a three-dimensional PCB with fine control of the distance between the printhead and the surface onto which the relevant material is deposited.

The inventive printing device advantageously allows for `hybrid 3D printing' of both conductive material (e.g. conductive metal as electrical tracks) and non-conductive supporting material (e.g. polymer base as the substrate) in a preferably fully automated process. The device permits rapid prototyping and short-series production of PCBs and solves the problem of long design-to-product life cycle, high cost of design exploitation, and high time and cost for small series PCBs and prototypes.

The provision of both the first and the second printhead on the same printing device allows for improvements in the quality, complexity and design freedom of the PCBs. For example, due to both materials being printed from the different printheads on the same printer, the intermediate products in the course of the production of the PCB need not be fully solidified before further material or components are added. This supports a good fit between materials, which is not possible in the processes of the prior art. Electronic components may be added and soldered in-situ before further layers of material or further components are added. The PCB may thus be built up in a step-wise manner without transferring it to different work stations. Furthermore, the possibility of keeping all intermediate products stationary before addition of further layers or components allows for precise alignment of said layers to one another. The printing device also provides high data and design protection, decentralized 'in-house' manufacturing, and reduces toxic waste and waste water by the additive manufacturing process.

The inventive printer provides the possibility of fully digital direct printing of freeform 3D objectives with conductive features inside as well as on the surface without the need of any tools (e.g. masks or molds).

In the sense of the invention, a "heater" is preferably a device configured to raise the temperature of a material directly or indirectly. The heater may preferably comprise on or more resistive coils. Indirectly raising the temperature of a material may comprise heating a component such as the printhead, in particular a reservoir of the printhead, which is configured for direct contact with the material.

In a further preferred embodiment of the invention, the first printhead is configured for generating single drops of molten metal of uniform diameter. Preferably, the first printhead is also configured for non-contact deposition of the molten metal. This preferably means that deposited material is preferably fully separated from the printhead before arriving at the surface to which it is deposited. Non-contact deposition of molten metal can advantageously be carried out at ambient conditions rather than a protected argon atmosphere, whereby droplets can have a higher compatibility with the non-conductive structure in comparison to inks.

The generation of single drops of molten metal allows for a high resolution and uniformity of the conductive elements, such that these also have a constant electrical resistance along their length. The droplets could be released initially in a liquid state. Such a state allowed for very round and uniform discrete droplets to be formed by surface tension. The skilled person is aware of how to adjust the nozzle of a printhead to achieve such a droplet deposition. Adjacent droplets could then merge before rapidly solidifying, such as to form a smooth, solid structure, which is not deformed by further process steps. Furthermore, the merged droplets are advantageously free of internal porous structures.

The first printhead preferably comprises or is connected to a reservoir for holding a molten metal. Means are preferably provided for moving the molten metal into a nozzle of the printhead, wherein the means preferably are based on pneumatic pressure, hydraulic pressure, gravity, capillary action and/or a pump. Preferably, the first printhead is configured for pneumatic or hydraulic droplet generation, wherein a pneumatic or hydraulic pressure of a secondary fluid is applied onto a molten metal in a reservoir such as to force the molten metal into a nozzle outlet. To this end, the first printhead preferably comprises a pressure generation device for adjusting the pressure of the secondary fluid, wherein the secondary fluid preferably flows into an antechamber above the liquid level in the reservoir and laterally into the nozzle outlet. The antechamber is preferably a volume located above the fluid level of the molten metal in the reservoir. The antechamber is preferably fluidly connected with other channels through which the secondary fluid is to flow.

The nozzle outlet of the first printhead is preferably of a material selected such that the molten metal has sufficiently low wettability with respect to the channel, so that the molten metal can flow through the nozzle outlet without spreading over the nozzle. The inner walls of the nozzle outlet preferably have a higher wettability with respect to the secondary fluid than with respect to the molten metal. A cross-sectional shape of the nozzle may also be configured to further reduce capillary action and contact between the molten metal and the walls of the nozzle outlet, wherein a star-shaped cross-section having two, three, four, five or more spokes is preferred. Preferably the secondary fluid flows through the spokes of the star-shaped cross section parallel to the direction of flow of the molten metal. This configuration allows the molten metal to remain within a central portion of the star-shaped cross section of the nozzle outlet, the central portion having a reduced surface area of contact with the flowing molten metal. Side channels are preferably arranged to open into the side walls of the nozzle outlet, such as to deliver the secondary fluid to the nozzle outlet. Preferably, the secondary fluid is a rinse gas. Molten metal preferably enters the nozzle outlet from the reservoir due to the gas pressure of the secondary gas in the antechamber and due to gravity. Entry of a droplet of a portion of molten metal into the nozzle outlet preferably causes an increase in the pressure of rinse gas entering the nozzle outlet from the side channels, such that a discrete droplet is released (or "torn off'), whilst the remaining molten metal is returned to the reservoir by capillary action. This process is preferably repeated sequentially, such that droplets are released in a regular and consistent manner.

The rinse gas preferably additionally acts as a sheath layer to prevent oxidation to the molten metal microdroplets. The rinse gas is preferably inert. Preferably (and in the Examples set out further herein) the rinse gas is nitrogen.

This is an especially advantageous technique for producing droplets of uniform size and is especially safe for use with molten metals. The technique is especially effective for producing uniform droplets from molten metals without contacting the surface onto which the droplets are to be deposited. This not only allows for uniformity of droplet size but also for cooling during the deposition.

In a preferred embodiment of the invention, the first printhead is a StarJet printhead as disclosed in US8877145B2. This printhead has been found especially suitable for use in a printing device according to the invention.

In a preferred embodiment of the invention, the printing device further comprises a pick-and-place robot head, the pick-and-place robot head preferably being configured to place electronic components at predetermined locations on a printed non-conductive structure and/or printed conductive elements and/or build plate, wherein the printing device preferably further comprises an in-line camera configured to verify picking and placement of the electronic components and/or to monitor print quality. The pick-and-place robot head is for example a pneumatic gripper or a similar device. Providing the pick-and-place robot head on the same printing device as the first and second printheads allows for a rapid one-stop production of PCBs without post-processing. Thus, electronic components may be applied between layers or in a stepwise manner to avoid mechanical conflicts, especially in highly complex PCBs.

The second printhead is preferably configured for printing the non-conductive material in liquid and/or gel state to form the non-conductive isolating areas of the 3D printed object. Any other non-solid form may be suitable. The second printhead may be configured in a similar or a different manner to the first printhead. As an example, the second printhead may correspond to the printhead of a Prusa i3 MK3 device.

Preferably, the second printhead comprises a filament feed unit. This preferably comprises an inlet for a polymer filament, which may be fed from a spool, a motor and optionally one or more gears. Alternatively, the second printhead may comprise a hopper and an extruder, these being configured to feed polymer granules. The filament feed unit or the hopper may provide the polymer filament or granules to a "hot-end". This is preferably a heated portion of the printhead and may comprise a heater in the form of a coil. The hot-end preferably comprises a chamber for holding molten polymer and a nozzle for releasing the molten polymer. Additional features such as side inlets for a secondary fluid, e.g. an inert gas of pulsating pressure, may also be provided depending on the type of polymer deposition to be carried out by the second printhead.

The heater of the second printhead is preferably distinct from the heater of the first printhead in that it is configured to reach a lower maximum temperature of heating. This is because the dielectric material used preferably has a lower melting point than the molten metal. Preferably the heater of the second printhead is configured to reach a maximum temperature of not more than 300 °C, more preferably not more than 150 °C. Preferably, the heater of the first printhead is configured to reach a maximum temperature of not more than 450 °C.

In a further preferred embodiment of the invention, the first printhead and/or the second printhead are moveable in the z-direction with respect to the build plate and/or the build plate is moveable in the z-direction with respect to the first printhead and/or the second printhead. The printing device may thus be used to adjust and set the distance between each printhead and the surface onto which material is to be deposited, which may allow for different cooling profiles to be used for different materials. At the same time, the printheads may be adjusting with respect to the build plate such as to keep the distance between the relevant printhead and an intermediate PCB product constant throughout the production of different layers.

In a further preferred embodiment of the invention, the printer comprises at least two printheads for printing two different materials. These may include all typical mechanical and control features required for operating said printheads. The printheads may be operable simultaneously or in sequence. Further post-processing steps such as brushing, cleaning or coating may thus be carried out at a single stop, further improving the speed of production of the PCBs and reducing the need for data-sharing across different manufacturing facilities. The printing device is thus especially suitable for rapid prototyping without data security risks.

Terms such as substantially, approximately, about, etc. preferably describe a tolerance range of less than ± 20%, preferably less than ± 10%, especially preferably less than ± 5%, and especially less than ± 1%, and include the exact value.

A person skilled in the art understands that technical features and advantages that have been disclosed in regards to the method described herein, equally apply to the printing device and vice versa.

### FIGURES

### Brief Description of the Figures

Without intending to be limiting, the invention will be explained in more detail with reference to exemplary embodiments and the following figures:
**Fig. 1****:** Schematic illustration of a conductive metal track printed such as to appear engraved on the surface of a polymer PCB base according to an embodiment of the invention.
**Fig. 2****:** Real printed sample whereby a conductive metal track printed onto a polymer according to a further embodiment of the invention.
**Fig. 3****:** Real printed sample of a populated circuit comprising a conductive metal track printed onto a polymer according to a further embodiment of the invention.
**Fig. 4****:** Scanning electron microscope image of a conductive metal track printed onto a base sheet before printing of a polymer structure on and around it and removing the base sheet according to an embodiment of the invention.
**Fig. 5****:** Scanning electron microscope image of a metallic conductive track printed onto a build plate without a base sheet before the printing of a dielectric material, such as to provide a smooth finish.
**Fig. 6****:** Schematic illustration of a partially populated circuit comprising a conductive metal track and conductive pads printed onto a polymer with grooves/recesses according to a further embodiment of the invention.
**Fig. 7****:** Schematic illustration of a method of manufacturing an electronic circuit according to a preferred embodiment of the invention, wherein grooves/recesses are formed in the non-conductive structure and conductive elements are printed in the grooves.
**Fig. 8****:** Schematic illustration and microscopic image of a cross section of an electronic circuit printed according to a preferred embodiment of the invention, wherein conductive elements are printed within grooves/recesses and enclosed between layers of polymer.
**Fig. 9****:** Schematic illustration and microscopic image of a cross section of an electronic circuit printed according to a further preferred embodiment of the invention, wherein conductive elements are printed on the surface of a polymer layer and enclosed by a further polymer layer.
**Fig. 10****:** Deconstructed schematic illustration of a three-dimensional electronic device as computer-aided model manufactured using a method according to a further preferred embodiment of the invention.
**Fig. 11****:** Photograph of a three-dimensional electronic device manufactured using a method according to a further preferred embodiment of the invention.
**Fig. 12****:** Schematic illustration of the circuit enclosed in the three-dimensional electronic device of Fig. 11.

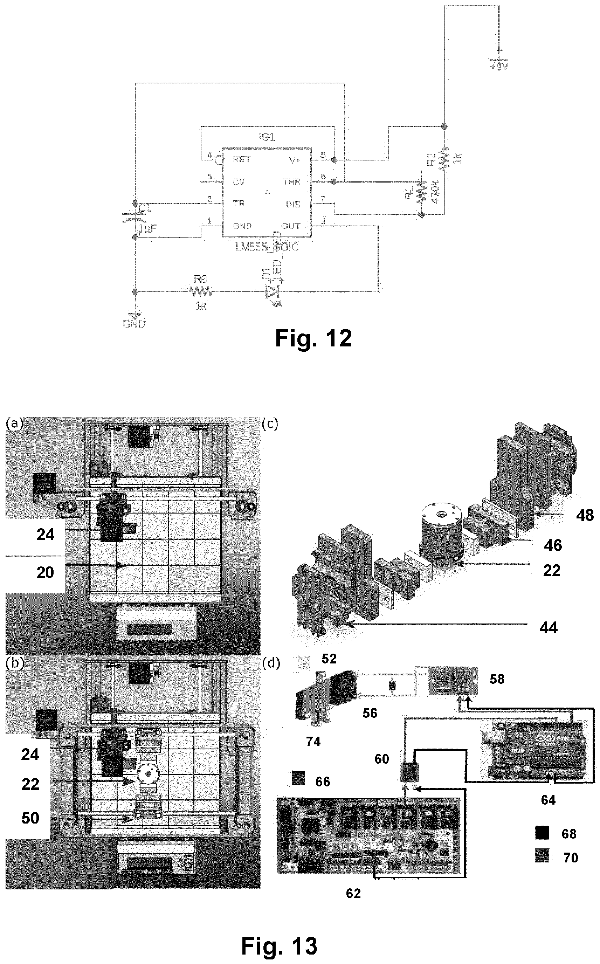

**Fig. 13****:** (a) Computer-aided (CAD) model of the open source Prusa i3MK3 3D printer with its single extruder for printing polymer. (b) CAD model of the proposed hybrid 3D printer with an integrated StarJet printhead onto the Prusa i3 MK3 printer. (c) Exploded view CAD model showing different fixtures and heat break elements (made from aluminium) for the dissipation of heat from the StarJet printhead. (d) A new control board with dual extruder capability replaced the single extruder control board. A control sequence is displayed showing the communication between the printer control board and the StarJet printhead.
**Fig. 14****:** (a) Photograph of Synkrotima, the hybrid printer developed as part of this research. (b) A printed model from Original Prusa i3 MK3 printer. (c) A printed model from the same CAD design as (b) but printed from Synkrotima illuminated the unhindered FFF printing performance after The StarJet integration.
**Fig. 15****:** Process methodology for the hybrid printing via Synkrotima, (a) an example of a 3D-CAD model with the assembly of polymer structure and conductive metal structure. (b) A sliced model on the hybrid slicer profile was created to assign extruder 1 (printhead 2) for the dielectric part and extruder 2 (printhead 1) for the electrically conductive part. Further, the generated G-code from this model is fed to Synkrotima. (c) Photograph of the final hybrid printed sample generated without human interference.

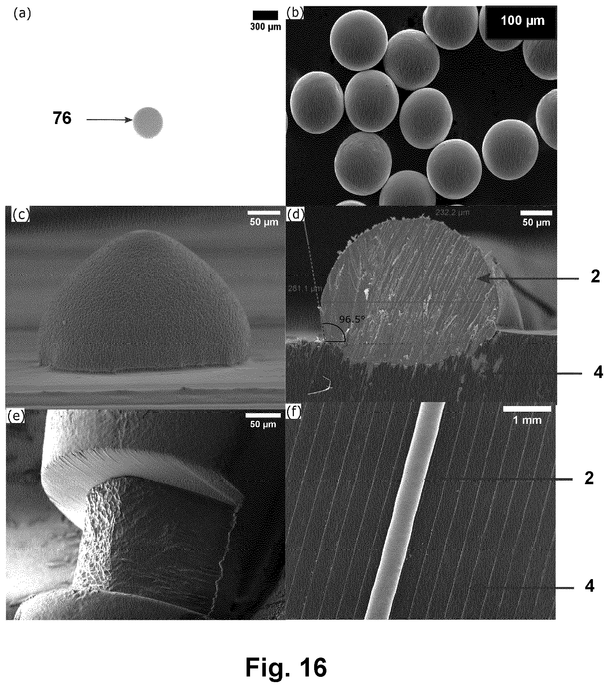

**Fig. 16****:** (a) Printed molten metal microdroplet from StarJet printhead captured by the stroboscopic camera in flight; (b) Scanning electron microscopic (SEM) micrographs of molten metal microdroplets printed into water; (c) Solidified sessile molten metal microdroplet on FFF printed PETG substrate with a contact angle of about 93 degrees. (d) Cross-section view of the solder line printed on PETG substrate with a contact angle of about 96.5 degrees. (e) Focused ion beam (FIB) cut section of the electrically conductive trace printed on PETG substrate; (f) SEM micrograph of the electrically conductive trace (solder line) printed at a dot spacing of 100 µm.

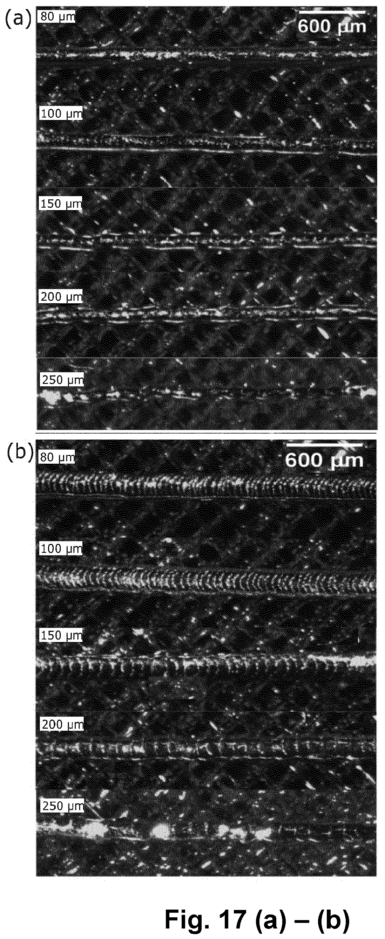

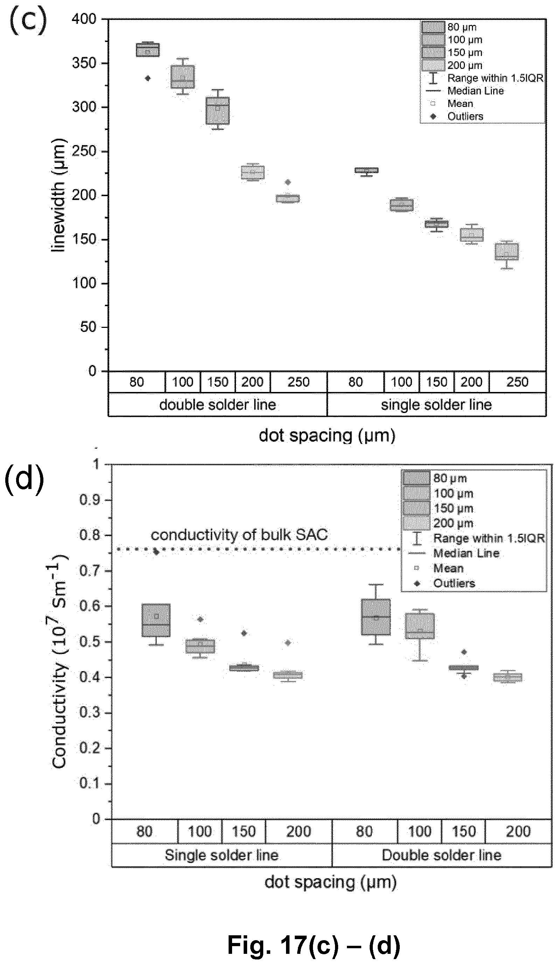

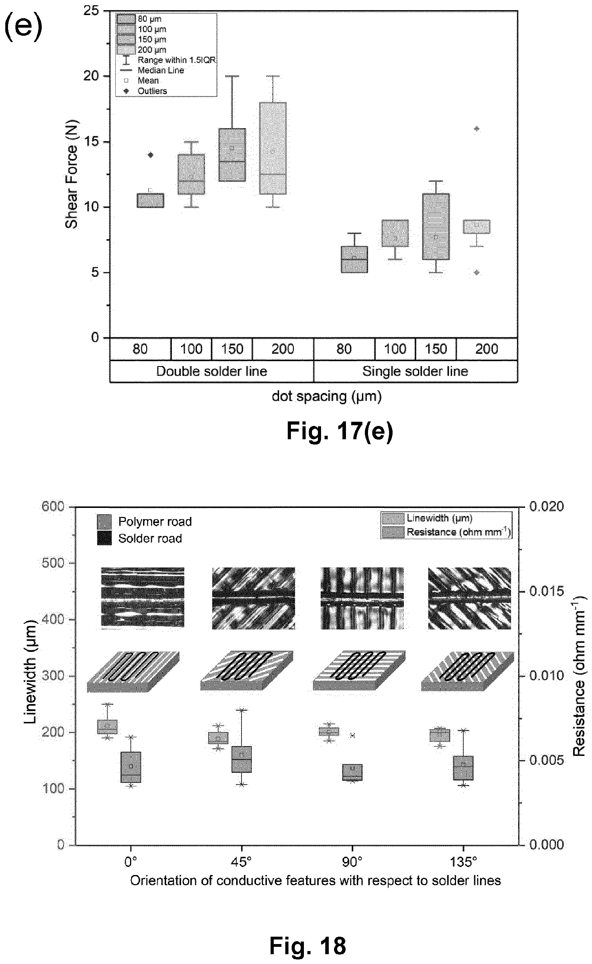

**Fig. 17****:** (a) Single solder lines and (b) double solder lines printed at different line widths of 80µm, 100µm, 150µm, 200µm, and 250µm, on PETG substrate; (c) Line width measured for single and double solder lines printed at varying dot spacings. The minimum dot spacing considered for printing samples is 80µm while the maximum is considered as 250µm; (d) measured electrical conductivities for single and double solder lines at different dot spacings, where the electrical conductivity of SAC305 solder of 7.69 × 10⁶ Sm⁻¹ is marked in dash line as the reference; (e) Shear-off forces of single and double solder lines printed at different dot spacings. Double solder lines show higher shear-off force owing to large line width. Measured shear-off for force for single and double solder lines is between 6N and 16N.
**Fig. 18****:** Linewidth and electrical resistance of electrically conductive traces printed at different orientations (0°, 45°, and 90°) with respect to the polymer.

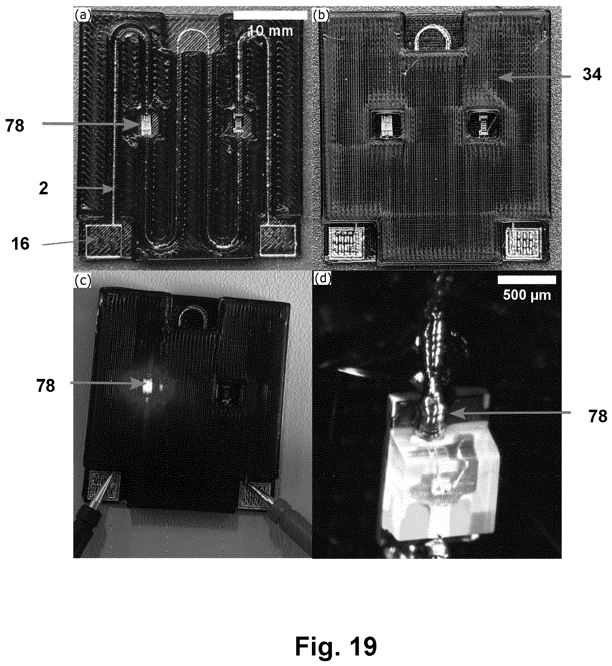

**Fig. 19****:** Fabricated hybrid 3D printed structure with embedded electronic components: (a) intermediate layer of the hybrid printed demonstrator, where two electronic components (a resistor and a blue LED) were place into the printed slots and conductive metal traces were printed into grooves/recesses; (b) completely hybrid printed demonstrator, where the printed conductive traces were covered by 3D printed polymer layers; (c) functional demonstration of illumination of the blue LED embedded in the polymer substrate from image (b), which was driven at the voltage of 2.9V with a measured current of 20 mA; Image (d) shows a close up the aforementioned LED displaying the solder printed on the contact pad of the LED by the molten droplets from the StarJet printhead.
**Fig. 20****:** Fabrication of a hybrid structure with embedded electronic components on different layers. (a) sliced model at a layer height of 1.7 mm with fabricated polymer groove; (b) sliced model at a layer height of 2.7 mm with the solder track and the LED covered by polymer; (c), and (d) sliced 3-dimensional structure printed via the StarJet in DoD (droplet on demand) mode. (e) The top view, and (f) back view of a hybrid printed 3D-model, where electrically conductive printed traces were fully embedded inside FFF extruded transparent green PETG polymer. Out-of-plane 3D metallic characters (P, 3, and D) were printed with the StarJet from SAC305 solder with a wall thickness of 530 µm.

### Detailed Description

The following disclosures are intended to explain and illustrate the invention in an exemplary manner without limiting the scope of protection.

The present invention is preferably based on layer-by-layer additive manufacturing or so-called 3D printing techniques for printing Printed Circuit Boards (PCBs) as well as electronic circuits distributed within/onto 3D structures / housing with integrated functional electronic components.

**Fig. 1** shows an example of a PCB printed according to an embodiment of the invention, in which the conductive metal tracks **2** are printed first before a layer of dielectric polymer **4** is printed between the conductive metal tracks. Dielectric polymer is additionally printed over the conductive metal tracks. This embodiment provides a smooth PCB surface in which the metal tracks **2** appear engraved in the dielectric polymer body **4** (the non-conductive structure).

In order to fabricate a flat 2D PCB with one layer of conductive tracks **2**, first the conductive metal tracks **2** are preferably printed onto a heated base sheet (not shown) using a direct metal printing technology such as a StarJet printhead (patent US8877145B2). The temperature for the base sheet should preferably be below the melting point of the conductive material used to print the conductive metal tracks **2.** These conductive traces **2** are laid out in the desired PCB electrical circuit layout. Next, these conductive traces **2** are preferably "engraved" in and in the meantime covered by a first layer of the dielectric material by printing the dielectric layer **4** on top. Since the non-conductive material printhead, configured for a technique such as fused filament fabrication (FFF), prints the insulating layer in a liquid/gel state, the insulating layers preferably flow around the conductive metal tracks **2** without disturbing the properties of the conductive metal tracks **2.** In this way, neither the material properties, nor the shape of the conductive metal tracks **2** are affected by this method, and the metal tracks **2** preferably remain in their form as printed initially. In subsequent steps, further layers of non-conductive material **4** can preferably be printed on top of the first layer to provide more mechanical stability and/or to add mechanical features like mounting holes, hinges, snap locks etc. or even a complete external housing for the electrical device. A significant advantage of this inventive approach towards printing the metal tracks **2** first on a pre-heated substrate ("base sheet") and then to fully embed them in a layer of non-conductive material **4** is the fact, that the surface exhibiting the metal tracks is perfectly even and very smooth (provided that the base sheet was sufficiently even and smooth). Thus, after finishing printing of the PCB, this can be peeled of the base sheet, can be turned around and can be easily populated by conventional soldering. **Fig. 2** illustrates, based on a post-processed photograph, a PCB manufactured according to this method, using a base sheet which has been peeled off the finished PCB. As can be seen, the printed PCB closely reflects the design shown in **Fig. 1****.**

The fabricated PCB according to this embodiment is a thin surface, with electrically conductive metal tracks engraved on the dielectric layer, as shown in **Fig. 2****.** The result is a PCB board with engraved conductive metal tracks providing a smooth surface finish. The layout of the substrate **4** and the electrically conductive metal tracks **2** are open to the creativity and the design capability of the party that wishes to put this invention into use. Therefore, this invention is not limited to one single embodiment.

In this particular example, the non-conductive material used is polyethylene terephthalate-glucose (PET-g). The conductive metal tracks are formed from a solder alloy SAC305 (Sn96.5Ag3Cu0.5). The overall dimensions of this printed PCB are 35 mm × 60 mm × 0.60 mm.

Soldering of electrical components **6** is done with a solder that has a lower melting point than the metal that was used to generate the metal tracks **2** by printing, to avoid re-melting of the tracks during soldering the electrical components. Depending on the size of the PCB, the turnaround time from design to printed PCB prototype board ready for population can be as low as a few minutes up to one hour. This is significantly faster than any 24h PCB express delivery service.

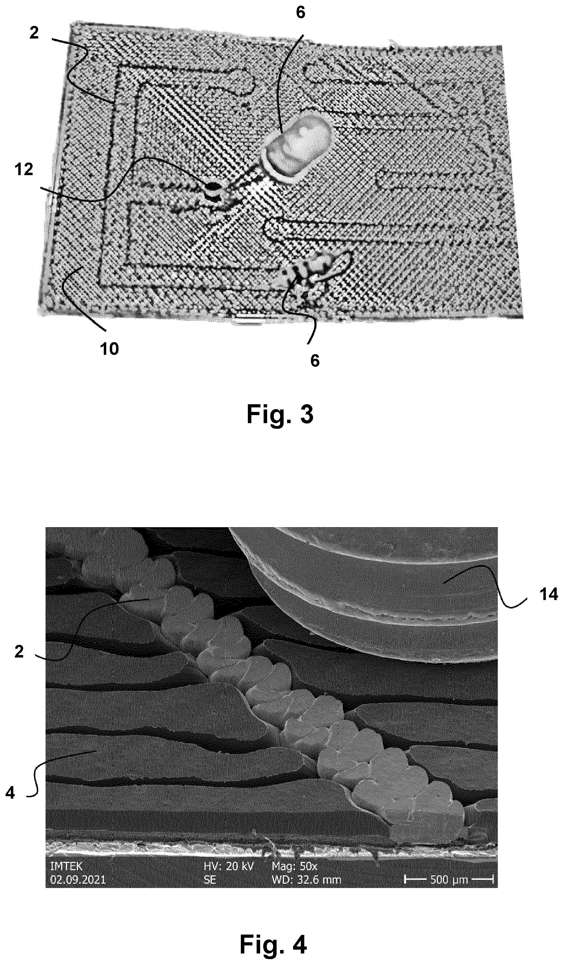

**Fig. 3** illustrates the PCB of **Fig. 2** after population with electronic components **6.** The image shows the PCB is provided with vias **12** (through holes) which allow connections from electronic components **6**, such as an LED and a resistor, to reach to the back of the PCB. In this example, the back **8** of the PCB is provided with metallic traces which can then be connected to the electronic components **6** on the front side **10** of the PCB. This PCB benefits from smoothness, compactness and high design fidelity. An alternative manner of populating the PCBs disclosed herein is placing electronic components, in particular SMTs, on the front side and soldering these to the conductive elements **2.**

The quality of the printed PCB is at least partially realized by the remarkable rheological properties achieved for the printed conductive elements **2.** A profilometer with a 12 µm diamond tip was used to measure the difference in height of the top surface of the conductive metal track **2** to the top surface of the non-conductive polymer layer **4.** The measured value was 130 nm, illustrating that the conductive metal tracks are completed engraved in the non-conductive polymer surface and are flush with its surface, therefore providing a smooth PCB surface. It was also advantageous that the PCB could be populated and an entire device printed on top of the printed planar PCB.

**Fig. 4** shows a scanning electrical microscope image of a surface of the device of **Fig. 2** and **Fig. 3** after removal of the base sheet. As can be seen in the image, the conductive trace **2** comprises discrete droplets which are merged into one another, such as to provide a continuous "road" of material of substantially constant cross section. The non-conductive structure **4** comprises substantially continuous "roads" of material which are adapted to the contours of the conductive trace **2**, such as to hold this firmly in place. Furthermore, the upper surfaces of both the conductive elements **2** and the non-conductive structure **4** are completely flat and are flush with one another, such as to present a single overall flat surface. This makes the PCB especially smooth und unsusceptible to damage.

In some further embodiments, the base sheet used to produce the PCB of **Figs. 1** and **2** can be omitted. For such an embodiment, suitable materials may be selected, which can be removed from a build plate without damage.

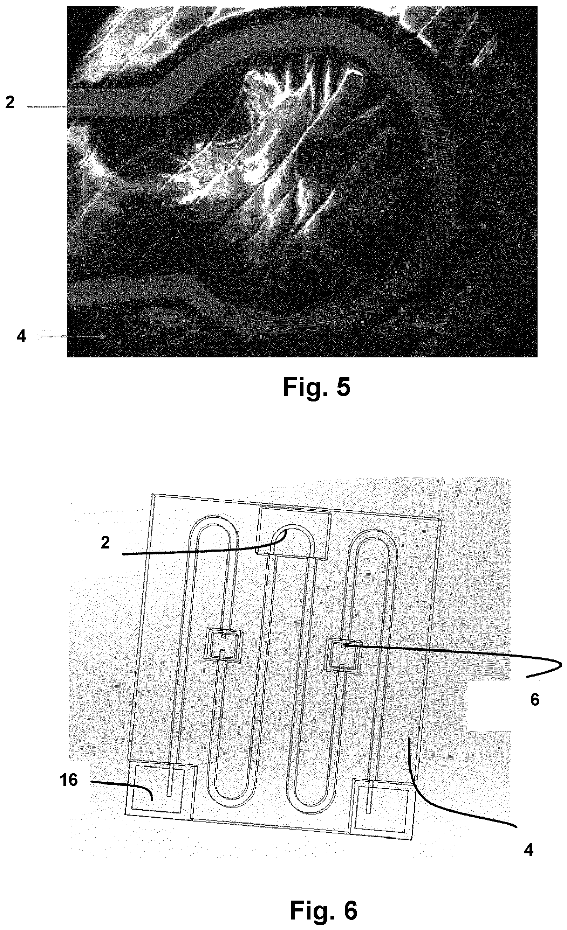

**Fig. 5** shows a scanning electrical microscope image of the upper surface of another PCB produced by a technique similar to that of **Fig. 1-3****.** However, both the conductive elements **2** and the non-conductive structure **4** are printed directly onto the smooth surface of a build plate without using an intermediate base sheet. The PCB was then removed from the build plate after solidification, such as to expose the surface which was in contact with said build plate. As can be seen, a tight fit is achieved between the non-conductive structure **4** and the conductive elements **2**, as well as a smooth surface quality.

A further embodiment of the invention is shown in **Fig. 6****.** Unlike **Fig. 1 - 4**, this PCB is printed by first laying the first layers of the non-conductive structure **4** onto a build plate. This is then formed such as to create channels and recesses, which are then populated with the conductive elements **2.** The conductive elements **2** of this embodiment include metallic traces as well as various conductive contact pads **16.** Such a PCB is configured for being populated in-situ with electronic components **6** applied to its front side, without lifting the PCB from the build plate and turning it over. The electronic components **6** can thus be placed on the surface of the PCB without moving this. Optionally, the same printing device is used to place and/or solder said electronic components **6.**

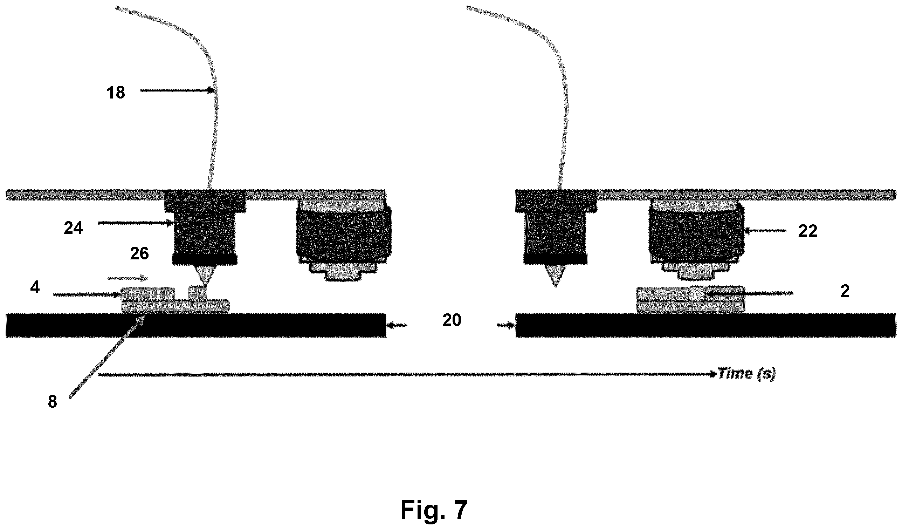

**Fig. 7** illustrates schematically a printing device and method for building the PCB of **Fig. 6****.** The device comprises at least two movable dispensers (namely, the first printhead **22** for printing molten metal and the second printhead **24** for printing a non-conductive material) for direct prototyping of PCB boards initially in 2 dimension and/or 2.5 dimensions, whereby electronic components are directly populated on the PCB during the printing process. The second printhead **24** provides the supply of non-conductive material **4** such as dielectric polymers and can build up three-dimensional objects via continuous moving in the x, y, and z-axis. In this embodiment, the non-conductive material **4** is a dielectric polymer provided in the form of a filament feed **18** which is melted and extruded by the second printhead **24.** One good example for a suitable printing technology for the second printhead **24** is found in the FFF based 3D printer.

Parallel to the FFF dispenser, the first printhead **22** is mounted next to it on the same axis system. The first printhead **22** supplies the conductive material and forms electrical features **2** such as electrical interconnections / wirings on PCB boards, contact pads, vertical interconnections, etc. One good example for a suitable printing technology is the StarJet based metal printer (see patent US 8877145B2). A suitable example of the FFF dispenser is described in Krishnanand et al [10]. The two printheads can deposit both materials subsequently and independently, layer by layer as described above.

As shown in the **Fig. 7****,** the non-conductive structure **4** is first laid out onto the build plate **20** and is configured to create grooves and recesses on its upward-facing surface. The grooves and recesses are then filled with molten metal to form the conductive elements **2**, which adapt to the form of said grooves and recesses, as will be shown in further figures, such as to form a stable overall structure. The non-conductive structure **4** preferably encloses and insulates the conductive elements **2** from at least three sides, preferably leaving only the upper side initially exposed for an electronic connection. The conductive element **2** may then be fully enclosed by the addition of further layers of non-conductive material, such as to fully isolate it. This embodiment is suitable for the rapid prototyping of PCB boards that are to be populated with electronic components afterwards.

A variant of the printing device of **Fig. 7** comprises an additional a pick-and-place head (e.g. a pneumatic gripper) mounted on the same or another x, y, z-stage as the printheads. The pick-and-place head is able to pick SMD components from a tray and to place them onto the printed surface (possibly applying some glue before placing to make the SMD parts stick to the surface better). With such an apparatus, a 2.5D printed PCB board or any other 3D printed electronic model, with directly integrated SMD components inside can be fabricated fully automatically. This embodiment requires neither any post processing of the printed sample nor any population of electronic parts after the printing run has finished. Moreover, it is suitable in scenarios where it is not possible to form interconnects for the electronics post the fabrication of the printed device, owing to the complexity of the design and/or the small available space due to the packing density of components.

After placing, the SMD components are directly soldered during the printing of the conductive metal tracks fully automatically. The non-conductive structures of the printed (3D) electronics could be fabricated via FFF, direct polymer jetting, or whichever polymer dispensing technique that provides good resolution and feature size for the non-conductive component. In this illustrated embodiment, FFF printing is used. The conductive metal tracks are preferably printed via bulk metal printing to ensure direct soldering of the SMD components. The bulk metal printing could be in the form of metal micro-droplets or a jet of metal.

An advantageous feature in this embodiment is that the metal lines directly printed onto the contact pads do not require any further soldering or post-processing steps. The conductive metal tracks form direct electrical interconnections with the contact pads and the SMD components in this case. It has been proven experimentally, that low resistance, high quality electrical connections can be achieved in metal tracks printed from SAC solder. The contact pads could be placed anywhere on the printed electronics as per the designers need. They can then be connected by printed metal tracks as per a digital design and covered by non-conductive material for protection or could be left open for further downstream processing.

Another feature of this embodiment is that the pick and place set up comprises in-line cameras on the machine, so that electronic components can be automatically picked, aligned and placed during the layer-by-layer printing sequence. The in-line camera can be used to verify the object being picked and its correct placement on the printing platform. The in-line camera could also be used for monitoring the status of the printing to ensure quality of the printed structures.

The invention, in particular the aforementioned embodiments, provides various surprising advantages. The invention preferably permits fully automated printing of complete and functional electronics assemblies, even with a 3D shape, arbitrary arrangement of electronic components inside and outside of the object, featuring multilayer circuits and interlayer connections. There may be no need for any kind of post processing after printing.

The invention further permits fully automated prototyping of PCB boards with a super smooth surface that can be populated later by SMT technology. Further, design flexibility of PCB circuits includes the possibility of providing multilayer PCBs with sites for contact pads and vias, electronic circuits on curved surfaces, etc. The manufacture may occur without the use of toxic chemicals as known from the prior art. The post-processing of PCBs by heat treatment or galvanization may also be made superfluous.

The invention additionally reduces the lead time enormously for customer specific PCBs. Once the concept to design phase is ready, the manufacturing time is preferably independent of the complexity of the design. The invention preferably does not require a centralized large factory set-up for small scale manufacturing of PCBs and is therefore an economical solution. Decentralized manufacturing provides additional hardware safety and avoids insertion of malicious chips during electronic manufacturing and transportation, sustainability due to short transportation distance. Decentralized manufacturing also provides additional design and knowledge protection in electric circuits.

The inventive solution also allows the possibility of printing the entire electronics device, including any housing, on top of the printed PCB in one run thereby reducing the overall production time needed to manufacture functioning electronics. There is preferably no need for employing LASERs or other chemical adhesives to solder the SMD parts to the printed electronics as they can be directly soldered during the print via bulk metal printing technique.

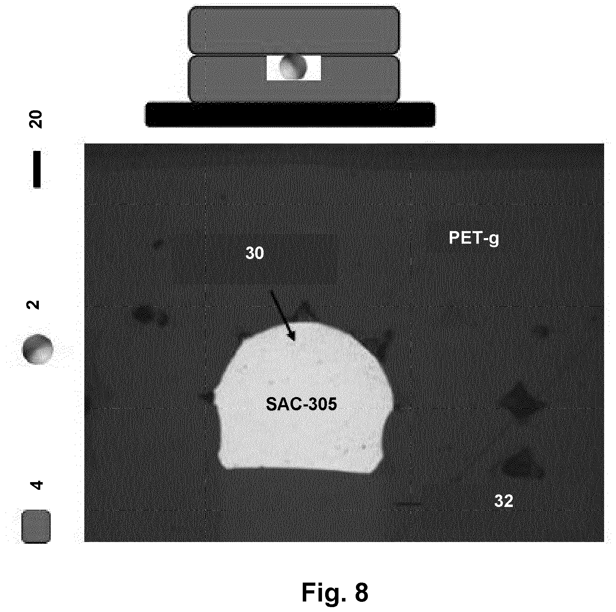

**Fig. 8** shows schematically a cross section of a PCB produced according to the technique of **Fig. 7**. As can be seen, the metallic conductive elements **2** are located within a channel, which is sandwiched between layers of the non-conductive structure **4.** The conductive elements **2** are thus fully electrically isolated. The whole PCB is built on top of the build plate **20** of the printing device, preferably without moving it from its initial position on said build plate.

**Fig. 8** also shows a microscopic scan of a cross section of a PCB produced according to the technique of **Fig. 7****.** The cross section of a conductive trace **30** can clearly be distinguished from surrounding printed polymer **32.** As can be seen in this embodiment, a lower portion of the conductive trace material **30** is relatively flat, and thus adapted to the shape of a channel floor which had been created in the non-conductive structure **4.** The upper portion of the conductive trace material **30** is round, and thus corresponds to a droplet, which had solidified before being deformed by the addition of further material. The cross section of the conductive trace is thus especially uniform. A close fit can additionally be seen between the conductive trace and the droplets of the polymeric material printed on top of it, such that this is well isolated.

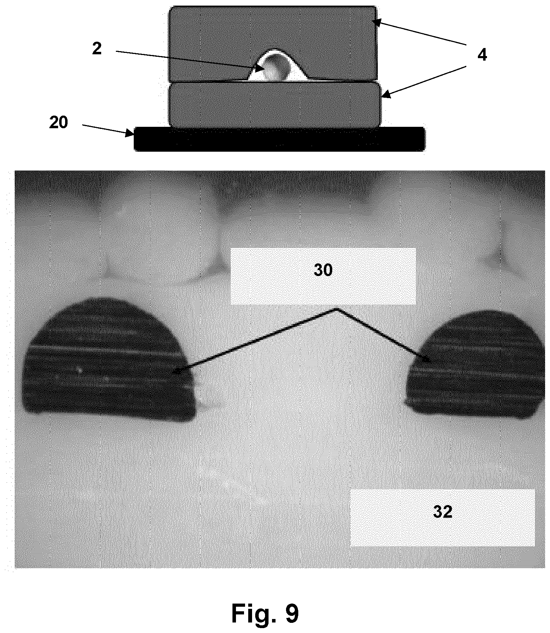

**Fig. 9** schematically illustrates a cross section of a PCB produced according to a slightly modified technique and using the printing device of **Fig. 7****.** In this embodiment, the initial layer or layers of the non-conductive structure **4** are configured to be substantially flat and free of channels. A conductive trace **2** is printed over the flat structure of the initial layers non-conductive structure **4** on the build plate **20.** Optionally, the conductive trace **2** is then connected and/or soldered with electronic components **6.** Further layers of non-conductive material may then be deposited on top, such as to isolate the conductive trace **2.** This technique omits the provision of channels and may thus be quicker and/or simpler. As can be seen in the cross-sectional scans also shown in **Fig. 9**, the cross section of the conductive traces **30** retain a similar form as shown in **Fig. 8****.** The packing of the non-conductive material roads is however tighter around the conductive traces.

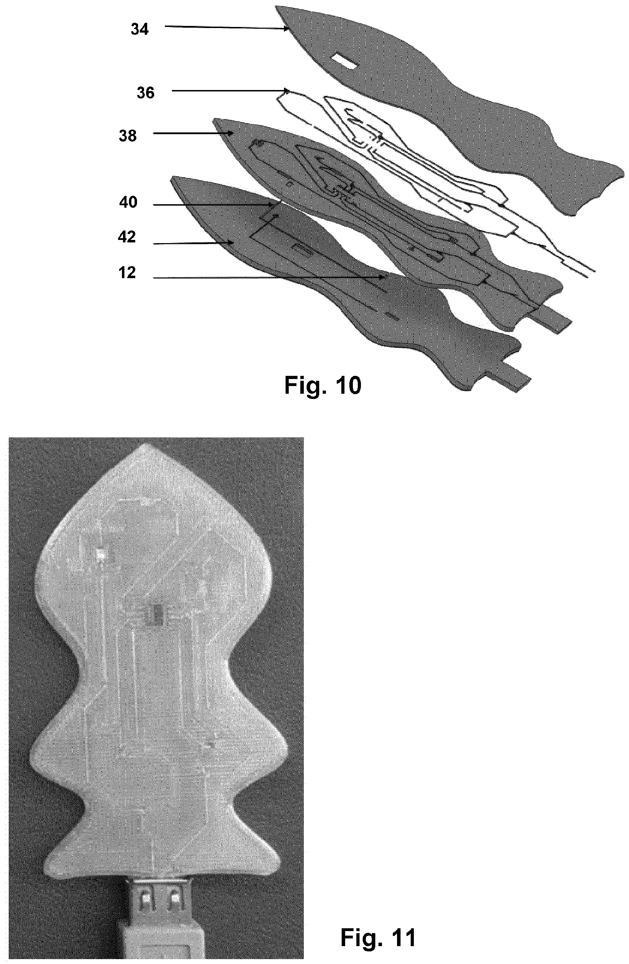

**Figs. 10** - **12** show a further example of a PCB manufactured according to a further preferred embodiment of the present invention. **Fig. 10** shows schematically an exploded image of different layers of a multi-layered electronic device housed within a printed structure. **Fig. 11** shows a photograph of the same device, produced experimentally, and **Fig. 12** shows the electronic circuit built into the device of **Figs. 10** and **11****.** The whole device is printed "in one go" on a single build plate **20** of a printing device.

As shown in **Fig. 10**, the electronic device comprises a first dielectric layer **42** which is configured as the base of the device. The first dielectric layer **42** is provided with channels and recesses configured to accommodate a first layer of conductive traces **40.** The first dielectric layer **42** is first printed before a molten metal is deposited as droplets into said channels, such as to form the conductive traces **40.** A via **12** is also provided in the first dielectric layer **42** and kept clear of molten metal. The deposition process of the molten metal is configured such that the droplets cool between release from the first printhead **22** and deposition on the first dielectric layer **42.** Distortion of the first dielectric layer **42** is thus avoided. Electronic components such as an LED **78** are then placed in the recesses of the first dielectric layer **42**, such as to contact the conductive traces **40.** Additional conductive material may be added for additional mechanical stability and connectivity of the electronic components. The conductive traces are arranged to be accessible at one end of the device, which is configured to receive power via a USB A connection.

This process is then repeated by the printing of a further dielectric layer **38** including further channels and then printing further conductive elements **36.** The solidified dielectric layer **38** and conductive elements **36** are then covered by an upper cover **34** for the device, which is in this case printed from the same polymeric material as the dielectric layers. The electrical circuit is thus fully enclosed in a fully populated device having a final shape.

The device was produced experimentally as shown in **Fig. 11** and connected to a power source via a USB cable. Operation of the circuit could be observed.

### EXAMPLES

The invention is further described by the following examples. These are not intended to limit the scope of the invention, but represent preferred embodiments of aspects of the invention provided for greater illustration of the invention described herein.

### Example 1: Printing Device "Synkrótima" - Fig. 13

A printing device was developed as an exemplary embodiment of the invention. This printing device was named "Synkrotima" and is shown in Fig. 13 and described below.

An open-source desktop printer, Original Prusa i3 MK3 (Prusa Research a.s., Czech Republic), see **Fig. 13**, was chosen as the base for Synkrótima for integrating the StarJet printhead for hybrid printing. Original Prusa i3 MK3 has the advantages of low cost, proven technology, easy operation, availability of spare parts, and an open system with easy customization. For the customizability of the printer, computer-aided design (CAD) models and controller board schematics are available in online repositories [P37].

**Figure 13(a)** shows the CAD model of the original desktop printer (top view) prior to integration of the additional SarJet printhead, and **Figure 1(b)** shows the CAD model after the mechanical integration of the StarJet printhead **22.** The hardware is designed to ensure that the StarJet printhead **22** moves in the x- and z-axis while the build platform moves in the y-axis. The StarJet printhead **22** is integrated next to the FFF printhead **24** by modifying the single default x-axis 3D printer set-up into a dual x-axis set-up.

The FFF extruder has a main body composed mainly of 3D-printed plastic parts, making it lightweight. While the StarJet printhead **22** has a main body of pure stainless steel, it weighs 786 g after lightweight re-designing. Thus, the dual x-axis design shown in **Figure 1(c)** redistributes the additional StarJet printhead **22** weight and stabilizes the motion in the x-and z-direction. This improves control and shape fidelity.

The 3D-printed parts (from PETG) of the Prusa printer have a heat deflection temperature (HDT) of 68 °C at 0.46MPa [P38], while the operating temperature of the StarJet **22** is fixed at 320 °C. Therefore, apart from mechanical stability, thermal management is also preferable for hybrid integration, see **Figure 1 (c).** The materials for fixing the StarJet printhead **22** on the 3D printer were suitably selected to dissipate the heat of the StarJet printhead before reaching the plastic parts of the Prusa printer to a temperature below the deflection temperature of 68 °C. These fixture materials include PEEK plates **48** and 3D-printed polyamide-6 with filled glass fibers and a heat break component **46.** Validation of the thermal management was tested by heating the StarJet Printhead **22** to 450 °C for more than 8 hours. The temperature was then measured at the plastic parts of the Prusa printer and was found to be lower than the deflection temperature of the material.

**Fig. 13(d)** further shows schematically a control mechanism for the Synkrótima printer, which is to be understood in light of the reference numerals set out further herein. Since Synkrótima operates as a single platform having two extruders (or simply printheads) for printing, an upgrade from the Prusa single extruder microcontroller board, EinsyRambo 1a, is provided to integrate the StarJet printhead **22** as the additional extruder (printhead). For this purpose, a new open-source microcontroller board, RUMBA+ [P39] **62**, is selected since it supports multiple extruders and is fully open-source for easy customization. The FFF printhead is assigned "extruder 1", whereas the StarJet is assigned as "extruder 2". Although the two printheads **22**, **24** integrated into Synkrótima have different printing principles, their control by a single RUMBA+ mainboard **62** is done in a way to keep the slicing methodology of the 3D printer in the future clean and without any additional user interference. To integrate the StarJet **22** printhead and make it work as extruder 2, an Arduino **64** with a MOSFET switch-based control **58** is implemented between RUMBA+ **62** and the pneumatic valve of the StarJet printhead. The Arduino board **64** controls the operating parameters of the StarJet printhead **22** and also converts extrusion signals from the RUMBA+ board **62** to switch the StarJet printhead ON and OFF accordingly.

With this, the hybrid printer, Synkrótima, consisting of two printheads **22**, **24** with two different AM working principles to print two materials in a layer-by-layer sequence is developed. The maximum print volume for hybrid printed electronics in (x, y, and z) directions is in this prototype (50 mm × 200 mm × 200 mm).

After integration, the offset between the FFF polymer extruder **24** and the StarJet molten metal printhead **22** is calibrated. The calibration method is done by printing metal on the edge of the L-shape polymer frame, which was previously printed via the FFF extruder.

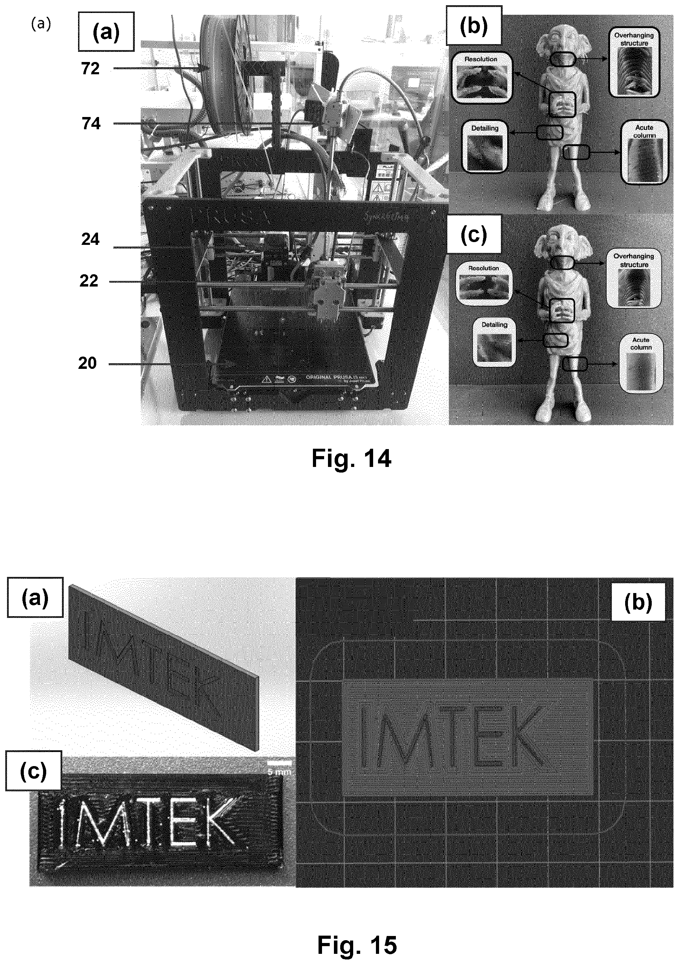

### Example 2: Hybrid printing calibration - Fig. 14

A non-conductive model was printed using the printing device before addition of the StarJet printhead **22** and after setting up the printing device to create Synkrótima, to investigate the effects of the adaptations made on the non-conductive printing performance.

The resulting set-up was characterized by evaluating any change in the print performance of the FFF printer due to the addition of the StarJet printhead **22.** The results in **Fig. 14** show almost no change in the polymer printing characterized via optical methods, while the measurement values via Vernier Caliper show a standard deviation of 258 µm in x- and y-direction compared to the model printed from the Original Prusa i3 MK3. No loss in printing quality is observed for small feature models printed via FFF on Synkrótima due to the extra weight of the StarJet **22** and its fixtures.

### Example 3: Layer Height Printed using Synkrótima - Fig. 15

One of the primary challenges with using two different print methodologies on a single platform is the difference in layer height that can be printed or resolution in the vertical direction. Roach [P13] observed this discrepancy in resolution when they used aerosol printing for conductive traces where the thickness of the line was around 10µm. For every layer printed by polymer (FFF layer height ranges from 150µm to 250µm for a standard nozzle of 400µm), more than 20 runs are necessary to eliminate the difference in the layer height between the conductive and non-conductive materials.

However, with Synkrótima, electrically conductive traces were printed with a layer height comparable to the polymer layer height. Therefore, electrically conductive traces and polymer can be printed layer-by-layer without requiring multiple runs otherwise needed to compensate for the difference in layer height, as seen by Roach [P13]. Thus, it bears the realization of sequential printing of polymer and electrically conductive traces similar to multi-material printing on FFF via polymer filaments without any modifications to the machine code. An example of the hybrid model of the IMTEK logo was printed (see **Fig. 15(c)**), where IMTEK characters were printed via the StarJet printhead. A substantially uniform product thickness could be achieved without the multiple layer runs of prior art technologies.

### Example 4: Droplet Deposition

The StarJet printhead **22** was further characterized by the stroboscopic set-up, which captures images of molten metal microdroplets **76** to determine the volume and position deviations. Stroboscopic characterization is used for DoD (droplet on demand) to pervade the parameters around which the StarJet printhead is most stable and can generate stable solder droplets with reproducible results. This method and the corresponding Setup can be understood further in light of previous publications [P36, P49].

The DoD printing was observed for frequencies of 2, 4, 6, 8, 10, 12, 14, 16, 18, 20, 25, 30, 40, and 50 Hz to characterize the droplet stability. A droplet is considered stable in the case when the position of the droplet remains consistent without the presence of any satellite droplet. For each frequency, the operation parameters (i.e. rinse pressure, actuation pressure, valve opening time) for the StarJet printhead **22** were tuned in order to achieve the minimum coefficient of variation (CV) in the droplet volume, zero satellites, and no missing droplet for more than continuously 5000 droplet jetting. The results showed clearly the high stability of the StarJet printhead **22** on printing single molten metal droplets. The operation frequency of 18Hz was selected for conductive feature printing in terms of speed and stability using the pulsating pneumatic technique. Pulsation is effected by opening a solenoid valve to release nitrogen gas. The final parameters for the StarJet system include, actuation pressure of 94 mBar, rinse pressure of 108 mBar, the valve opening time of 14 ms, reservoir temperature of 320 °C.

The experiments showed highly uniform droplet size and a rapid droplet solidification after merging to form a continuous conductive trace **2** on a non-conductive structure **4.**

The molten metal printing accuracy and reproducibility of Synkrótima was further assessed by five parameters:
1. Consistency in the placement of sessile droplets measured via consistent dot spacing between the droplets
2. Consistency in the diameter of sessile droplets.
3. Deviation of droplets in the x and y-axis.
4. Shear-off force for single sessile droplets.

### Example 5: Droplet Spacing, Consistency, Deviation in x- and y-axis, Shear-off force

To assess the consistency in the dot spacing of printed droplets, a series of single solder droplets were printed at a set dot spacing of 1500 µm. Moreover, the sessile droplets have adequate distance between each other which is necessary to assess the deviation on the x- and y-axis. The aforementioned parameters (1 - 4 of Example 4) are assessed on the printed droplets using the imaging software ImageJ. For the image analysis, a set of two droplets are chosen in the frame, and the measurement of the diameter of printed droplets, the dot spacing between the droplets, and the deviation of droplets on the x- and y-plane from each other is carried out.

**Table 1: Printing accuracy of StarJet for 50 printed droplets at a set dot spacing of 1500 µm. The values displayed in the Table are the average measured values of the 50 printed droplets. A factor ±10µm of uncertainty in the measurement has to be considered. Percentage deviation on the x-axis is a minuscule 0.02 while the relative percentage deviation on the y-axis is 1.9.**

| Size of sessile droplet (µm) | Print height (mm) | Set Dot spacing (µm) | Measured dot spacing (µm) |
|---|---|---|---|
| 285 ± 15 | 7 | 1500 | 1531 ± 22 |
| Deviation of droplet in x-axis | % deviation in x-axis | Deviation of droplet in y-axis | Relative % deviation in x-axis |
| (µm) | (µm) | (µm) | (µm) |
| 32 | 0.02 | 15 | 1.9 |

Table 1 shows the averaged value of droplet diameter, dot spacing, and deviation on the x- and y-plane for the image analysis performed on 50 sessile solder droplets. The average size of diameter observed for the printed droplet using a chip of diameter 183µm is 288µm. The CV (coefficient of variation) of the droplet diameter for the measured droplets is 0.05%. The percentage deviation on the y-plane is a minor 0.02% while the relative percentage deviation observed in x-plane is 1.9%.

The printing accuracy measured from the set dot spacing and the measured dot spacing is an impeccable value of 99.86%. Therefore, the first three parameters for assessing the StarJet printhead's performance present promising results.

To evaluate the fourth parameter, an assessment of shear-off force for a single solder droplet is performed to get an initial idea of the adhesion of a single droplet on the polymer surface. For this analysis, a sample is prepared with 40 solder droplets printed on it. A bond tester, Dage4000, is used for this quantification. A chisel tool is placed at a shear-off height of 20 µm with respect to the substrate. The DS100KG cartridge measures the force at the tool, which is moved at 250µms⁻¹. The average shear-off force obtained for a single solder droplet printed on the polymer substrate is 1800mN.

### Example 6: Cross-Sectional Area and Aspect Ratio - Fig. 16

For AM conductive traces, it is advantageous to achieve low electrical resistance for PE (printed electronics) and 3D electronics applications. One approach is to use a metal with intrinsic high conductivity such as silver (1.59 × 10⁻⁸ Ωm) and copper (1.72 × 10⁻⁸ Ωm), while another approach could be to AM electrical traces with high-cross section area so that the overall electrical resistance reduces. In this section, it is explained in detail how high aspect ratio lines with high-cross-section area (line width similar to "Voxel8", see P20) were formed presenting clear advantages in terms of low resistance and layer height compatibility with FFF technology. The ability to fabricate high aspect ratio (width/height) electrically conductive traces presents the scope for printing large-area 3D electronics.

Shape fidelity of molten metal microdroplets was evaluated for the solder droplets in flight after being released in a non-contact manner from the StarJet printhead **22**, see **Fig. 16(a)**, in a water medium (see **Fig. 16(b)**), on a PET-G substrate printed via an FFF printhead **24** (see **Fig. 16 (c)**), and as a cross-section of metal trace printed on PETG substrate (see **Fig. 16(d)**). The variation in the droplet diameter between the droplet in air and water was about 12µm. When printed on a PET-G substrate, the droplet spreads on the surface with a contact angle of about 93 degrees. The aspect ratio of single droplets printed on PET-G substrate was about 0.7. Therefore, the molten metal microdroplets printed on PET-G substrate show an aspect ratio (greater than 0.1) while maintaining a contact angle close to 90 degrees (a contact angle below 90 degrees was considered a good wetting angle); see **Fig. 16(c)****.** A cross-section of the metal traces printed on PETG shows a high aspect ratio of 0.8, see **Fig.16(d)****.**

The high cross-section area conductive traces helps to appreciate the closeness to the bulk material in terms of the density of internal structure, which can be observed from the FIB cut performed on the electrically conductive metallic trace printed on PET-G substrate. The lateral size of the FIB cut was kept larger than 280µm (diameter of molten metal microdroplet) to inspect the internal structure at the intersection of two molten metal microdroplets.

### Example 7: Electrical Resistance and Morphology of Conductive Traces - Fig. 17

The seamless merging of molten metal microdroplets, see **Fig. 17**, results in the conformal conductive lines.

Electrically conductive traces preferably have a low electrical resistance to ensure the application of multi-material additive manufacturing for 3D electronics. Synkrótima neatly facilitates this transition by printing electrically conductive traces with electrical resistance 12 times lower than the state-of-the-art technologies that use nanoparticle-based inks [P40].

To print electrically conductive traces, molten metal microdroplets dispensed from the StarJet preferably merge to form straight lines with smooth edges. Any bulging or necking will lead to sudden reduction or increase in the line cross-section areas, and therefore affect the electrical resistance.

To evaluate the effect of dot spacing, samples are prepared with solder droplets printed on a polymer substrate at varying dot spacings. Since the average size of droplet diameter achieved is 288µm, the merging of droplets begins at a dot spacing of approximately 250µm which is lesser than the droplet diameter, therefore, droplets can overlap each other to form a line. As a result, the maximum value of dot spacing set for the experiment is 250µm while the minimum value is kept at an exaggerated value of 80µm. The different values of dot spacing used for this subsection are: 250µm, 200µm, 150µm, 100µm, and 80µm. The printed samples contain solder structures at varying dot spacing in the form of single solder lines and double solder lines (one line on top of another). Double solder line assessment is done to evaluate the enhancement that can be provided to the properties of solder structures by comparing the results of single solder lines and double solder lines. This evaluation was accessed based on morphological, adhesive, and electrical properties. Each variant comprised a sample population of 20. Subsequently, each sample underwent three measurements, resulting in a cumulative count of 60 measurements for each box plot. The identical sample population was subsequently employed for both shear-off testing and resistance measurement.

**Fig. 17(a)** and **(b)** shows the microscopical top view of the printed line structure with aforementioned dot spacings for both single line and double line. It can be observed that the smaller the dot spacing, the less irregularity of the printed line shapes. Therefore, smaller dot spacing is a preferable option for printing good solder lines. The minimum dot spacing was preferably 100µm. At dot spacings greater than 100µm, the printed metal traces did not form free-standing structures as the droplets were consistently sufficiently close to each other.

The width of solder lines printed on polymer substrate at different dot spacing is inspected for single solder lines and double solder lines, and the results are plotted in **Fig. 17(c)****.** For line width measurement, microscopic images capturing 6 different sections of the printed solder lines are assessed by making 10 measurements on each image. Therefore, each data point below corresponds to 60 measurements. A linear decrease in the line width can be seen for both single solder lines and double solder lines. The lesser the dot spacing for solder lines, the closer are the printed droplets to each other, and therefore the greater the fusion between the droplets and the wider and smoother are the printed lines.

Electrical resistance of the conductive lines is measured via a 4-wire electrical resistance measurement method using an Agilent 34401A set-up. All the measurements were performed at room temperature. In order to reduce the noise in measurements, the 4-wire measurement was performed at a high current of 3 amperes. Standard electrical probes with square pads were used for contact with the printed metal traces.

The variation of electrical resistance of the printed electrically conductive traces was affected by varying the dot spacing, starting from 250µm, see **Fig. 17(d)****.** It also shows excellent conductivity for lines printed with a dot spacing of 80µm and 100µm. As expected, a linear decrease in the conductivity is observed for increasing the value of dot spacing. Since it has been established that the lines printed at 80 µm dot spacing can form hanging structures, the dot spacing of 100µm is the preferred value for sample production which shows 70% conductivity compared to the bulk solder material SAC305.

As a further assessment the adhesive properties of printed lines at different dot spacing were analyzed, which was evaluated via a shear-off test. **Fig. 17(e)** shows measured shear-off forces for single and double solder lines at the aforementioned dot spacings. The resulted shear-off force ranged from 6N to 16N. Higher shear-off force is observed for the double solder lines. The line width for double solder lines is larger than the single solder lines, therefore it is reasonable that the shear-off force needed to destroy part of the double solder line is higher than the single solder line. However, the shear-off force remains more or less the same for all the dot spacings for double solder lines, whereas a decreasing trend in shear-off force is observed for the single solder line. All in all, the shear-off force measurement does not seem to play a significant role in the selection of dot spacing for the line printing experiments since the variation observed in shear-off force is minuscule for single and double solder lines separately.

For single solder lines, the lines with dot spacing of 100µm show a mean shear-off force of 7.20N which is higher than the shear-off force obtained for other variations of dot spacing. Overall, a line with dot spacing 100 µm empirically was considered to provide the most suitable result for the morphological properties, adhesive properties, and electrical properties of the solder lines. Hence, for further hybrid printing experiments, a dot spacing of around 100 µm is preferred.

### Example 8: Electrically conductive traces independent of non-conductive build orientations - Fig. 18

In orderto keep the multi-material additive manufacturing process as simple as possible for a higher freedom in designs and applications it is preferred that the printed polymer layer does not influence the conductive metal printing.

The illustration of polymer road and electrically conductive traces in Fig. 18 defines different build orientations (0_{°}, 45_{°}, and 90_{°}) that have been examined in this example. Each variant comprised a sample population of 20. Subsequently, each sample underwent three measurements, resulting in a cumulative count of 60 measurements for each box plot. The build orientations here are the different orientations at which the electrically conductive traces are built on the printed polymer layer. The effect on electrical and morphological properties of electrically conductive traces printed on polymer substrate at varying build orientations could put design or slicing restrictions on 3D models. Therefore, the effect of different build orientations on the shape fidelity and the electrical resistance of electrically conductive traces was tested by measuring the linewidth and the electrical resistance per mm. 3D models were prepared (see illustrations (in blue) in Fig. 18) by placing the electrically conductive traces at different polymer raster angles. For clarity, the illustrations of build orientations between polymer 4 and electrically conductive trace 2 and real-life sample images are added to the graph in Fig. 18. The graph shows the electrical resistance per mm and the linewidth at different build orientations (N=60).

The standard deviations in linewidth in 0_{°}, 45_{°}, and 90_{°} are 19.0µm, 14.9µm, 10.3µm, and 12.9µm respectively. At the same time, the standard deviations in electrical resistance per mm in 0_{°}, 45_{°}, and 90_{°} are 1.1mΩ, 1.5mΩ, 1.0mΩ, 0.96mΩ respectively. Therefore, from the above results, the effect of build orientation on the shape fidelity and the electrical resistance of the electrically conductive traces is below 10% and has a minimal impact on the additive manufacturing of conductive metal traces. One possible reason for this result could be the at least partial melting of the polymer roads by metal droplets creating a less corrugated structure. The deviation observed could be further minimized by employing a higher-resolution polymer printer so that the surface unevenness could be reduced. The non-dependence of the electrically conductive traces on the build orientation of polymer roads makes this methodology robust for any free-form 3D printing of electrically conductive traces embedded in polymer substrates for future scope.

### Example 9: Hybrid Printing Code Generation

A further aspect of the one-stop print methodology involves the generation of a single machine code, commonly called G-code, for hybrid 3D printing. The G-code file for a 3D printer consists of the position and extrusion parameters of the model to be printed, along with control segments for heating and cooling operations. A software (in this case, Prusa Slicer Edition v1.40.1 software, Prusa Research, Czech Republic) was used to slice a standard triangle language (STL) file of the desired 3D CAD model into different layers generating the G-code file. However, for the machine to recognize the parts in the model to be printed with FFF 24 and with the StarJet printhead 22, printheads for the different print parts are declared in the slicer software. This declaration procedure consists of the following steps:
- Step 1: design the CAD model of the hybrid part as a CAD assembly containing the polymer and the electrically conductive parts. The two parts are then saved as two different STL files, polymer and metal, see **Fig.15(a)****.** This is indicated by the separated non-conductive structure shown in the CAD interface.
- Step 2: a hybrid slicer profile mimicking multi-material printing is created on the Prusa slicer software, where FFF printing parameters are saved as extruder 1, and the StarJet print parameters are saved as extruder 2.
- Step 3: the two STL files are imported in the hybrid slicer profile, where extruder 1 is assigned to print the polymer part, and extruder 2 is assigned to the conductive part **15(b).**

Subsequently, the input hybrid model is sliced, and the generated G-code is sent to Synkrótima. To ensure reliable results, the proactive step of preparing both printheads before starting the first print was taken. This preparation involves moving the printheads outside the designated printing area, so they can dispense a certain amount of material which is referred to as priming the printheads. Thus, with this integration and methodology, hybrid 3D models can be directly printed, and neither the polymer material nor the conductive material requires any post-processing.

In the following examples, samples were printed by multi-material additive manufacturing on Synkrótima. The printing height between the StarJet printhead nozzle **22** and the build plate **20** or substrate surface was 4mm.

### Example 10: Sample Circuit Comprising LED - Fig. 19

Examples of hybrid 3D-models were printed to demonstrate the potential of the developed Synkrótima platform. The first example, see **Fig. 19 (a)** and **(b)**, shows a hybrid model where meandering electrically conductive traces **2** with contact pads 16 were printed using the concept described for **Fig. 7** in polymer grooves and then covered by polymer layers. In the hybrid model, five segments (two contact pads, two slots for electronic components, and one slot for curved traces) were left uncovered for performance evaluation.

In this test model (with dimensions of 30 × 40 × 4 mm), a circuit of conductive traces was designed which includes bending of solder traces as curves with 2250µm as the radius of curvature. The line width of the printed solder line was 350µm with a conductivity of 2.25 × 10⁶ Sm⁻¹. The electrical trace was printed in a grooved polymer structure and was further covered with polymer to make an enclosed hybrid structure. The two electronic components, an SMD resistor (size 0603) with 1000Ω and a SMD blue LED **78** (ROHM Semiconductor, size 0603, 470 nm), were directly interconnected via printed solder lines (see **Fig.19 (d)**).

The workflow of hybrid printing this test model is described as follows:
1. Generate G-code for dual extruder printing using slicing software as described in Example 9.
2. Insert a delay in the G-code for placing the electronic component manually before the conductive traces **2** are printed at the intended layer.
3. Pick and place the electronic component **6** at the designed location when Synkrótima is on pause mode.
4. Resuming the printing via software, the second extruder (StarJet printhead **22**) gets activated and prints conductive traces as well as directly interconnecting the electronic components **6** to the rest of the electrical circuit.
5. Switch to the first extruder (FFF) **24** to print polymer and covers the printed conductive solder traces **2.**

The example shows the rapid creation of a fully functioning electronic device produced in a single printing device.

### Example 11: Sample Circuit Comprising LED and Surface Traces - Fig. 20

A further example, see **Fig. 20**, shows a hybrid 3D model with electrically conductive traces and a blue LED **78** fully embedded in polymer layers **4** leaving the contact pads **16** exposed for power inputs. A CAD model is prepared with grooves in initial layers where an SMD LED **78** is embedded in polymer layers **4** with conductive traces **2** reaching out to contact pads **16,** adding the provision to test the functionality of the LED. After several layers of polymer **4,** an endeavor is made to print a 3D structure via StarJet printhead **22** to demonstrate the printing performance of StarJet in printing 3D metal structures. A step-by-step description of the printing process is described in **Fig. 20 (a) - (d)****,** where the sequence in which the parts are printed on Synkrótima is showcased layer-by-layer via slicing software. **Fig. 20 (a)** shows the model at a layer height of 1.7mm where the polymer groove is already fabricated and the printing of molten solder droplets occurs at this layer height. The line formed by the conglomeration of molten solder droplets is highlighted in blue, printed by extruder 2 (StarJet) while the polymer is rendered in yellow, printed by extruder 1 (FFF). After this layer, a delay was provided in the G-code and the machine stopped printing and came to a halt. An LED is placed at the position in marked red circle in **Fig. 20 (a)** and thereafter the print resumes. **Fig. 20 (b)** illustrates the model at a layer height of 2.7 mm where the solder trace and the LED were covered by a polymer layer. A small opening at the base of the structure was left for the contact pad **16.** The printing capability of the StarJet printhead **22** to print 3-dimensional structures via molten solder droplets is manifested in **Fig. 20 (c) - (e)****.**

**Fig. 20 (e)** shows the fully functional printed hybrid model with working LED **78** and 3-dimensional structure printed from molten solder droplets. As the PETG polymer is semi-transparent, the embedded LED and solder traces in the polymer structure can be clearly seen against light in **Fig. 20 (f)****.** The LED is placed at a height of 1 mm from the top polymer surface. The embedded LED **78** shows complete functionality when a power source is applied across the contact pads, visible in **Fig. 20 (e)****.** The 3D out-of-plane letters printed on top of the model in **Fig. 20 (e)** demonstrate the capacity of the printer to expand in the third dimension. Advantageously, surface-mounted devices can also be integrated with semiconductor electronics to create fully printed functional electronics, thereby eliminating any assembly or packaging steps. Furthermore, as the devices of example 10 and 11 are printed using bulk metal, there is no need for post processing steps such as sintering to fix the conductive traces.

### Reference Numerals:

- **2**: Conductive Traces
- **4**: Non-conductive Structure
- **6**: Electronic Component
- **8**: Back side of the PCB
- **10**: Front side of the PCB
- **12**: Via
- **14**: Fixture used for SEM Imaging
- **16**: Conductive Contact Pad
- **18**: Filament
- **20**: Print bed / Build Plate
- **22**: First Printhead
- **24**: Second Printhead
- **26**: Tool Path
- **28**: Channel
- **30**: Cross-Section of Printed Conductive Trace
- **32**: Cross-Section of Printed Polymer
- **34**: Upper Cover of 3D PCB Device
- **36**: Conductive Traces of Second Layer
- **38**: Second Dielectric Layer
- **40**: Conductive Traces of First Layer
- **42**: First Dielectric Layer
- **44**: Fixtures for Thermal Management
- **46**: Heat Break Element
- **48**: PEEK plate
- **50**: Mounting Fixtures
- **52**: Trigger for Valve
- **56**: Flyback Diode
- **58**: MOSFET switch module
- **60**: Optocoupler
- **62**: Rumba + Microcontroller Board
- **64**: Arduino UNO board
- **66**: Output from Extruder
- **68**: Ground Wire
- **70**: Live Wire
- **72**: Filament Spool
- **74**: Solenoid Valve
- **76**: Molten Metal Droplet in Flight
- **78**: LED

### References:

[P1] T. Wohlers, I. Campbell, O. Diegel, R. Huff, J. Kowen, Wohlers report 2020: 3D printing and additive manufacturing state of the industry, Wohlers Associates, Fort Collins, Colo., 2020.
[P2] A. Ben-Ner, E. Siemsen, California Management Review 2017, 59, 2 5.
[P3] R. Lacroix, A. Timonina-Farkas, R. W. Seifert, Journal of intelligent manufacturing 2023, 34, 1 281.
[P4] P. Radfar, S. R. Bazaz, F. Mirakhorli, M. E. Warkiani, Journal of 3D Printing in Medicine 2021, 5, 1 51.
[P5] P. K. Collins, R. Leen, I. Gibson, Virtual and Physical Prototyping 2016, 11, 4 295.
[P6] A. Jhinkwan, S. Kalsi, Pankaj, In ADVANCEMENTS IN CIVIL ENGINEERING: COSMEC-2021, AlP Conference Proceedings. AIP Publishing, 2023 020028.
[P7] F. Tsegay, R. Ghannam, N. Daniel, H. Butt, ACS Applied Engineering Materials 2023, 1, 4 1142.
[P8] Y. Zheng, W. Zhang, D. M. Baca Lopez, R. Ahmad, Polymers 2021, 13, 12.
[P9] E. MacDonald, R. Wicker, Science (New York, N.Y.) 2016, 353, 6307.
[P10] G. T. Carranza, U. Robles, C. L. Valle, J. J. Gutierrez, R. C. Rumpf, IEEE Transactions on Components, Packaging and Manufacturing Technology 2019, 9, 6 1176.
[P11] R. E. Giachetti, M. I. Alvi, Computers in Industry 2001, 45, 2 177.
[P12] J. A. Castrovilla, JOM 1989, 41, 4 25.
[P13] D. J. Roach, C. M. Hamel, C. K. Dunn, M. V. Johnson, X. Kuang, H. J. Qi, Additive Manufacturing 2019, 29 100819.
[P14] A. Nazir, O. Gokcekaya, K. Md Masum Billah, O. Ertugrul, J. Jiang, J. Sun, S. Hussain, Materials & Design 2023, 226 111661.
[P15] E. DeNava, M. Navarrete, A. Lopes, M. Alawneh, M. Contreras, D. Muse, S. Castillo, E. MacDonald, Three-dimensional off-axis component placement and routing for electronics integration using solid freeform fabrication.
[P16] D. Espalin, D. W. Muse, E. MacDonald, R. B. Wicker,The International Journal of Advanced Manufacturing Technology 2014, 72, 5-8 963.
[P17] D. Loaldi, L. Piccolo, E. Brown, G. Tosello, C. Shemelya, D. Masato, Micromachines 2020, 11, 5.
[P18] G. L. Goh, S. Agarwala, G. D. Goh, H. K. J. Tan, L. Zhao, T. K. Chuah, W. Y. Yeong, The International Journal of Advanced Manufacturing Technology 2018, 94, 1-4 1309.
[P19] J. A. Lewis, B. Y. Ahn, Nature 2015, 518, 7537 42.
[P20] Engineering.com, Voxel8 returns to 3d print shoe uppers, 2023-04-21, URL https://www.engineering.com/story/voxel8-returns-to-3d-print-shoe-uppers.
[P21] A. H. Espera, J. R. C. Dizon, Q. Chen, R. C. Advincula, Progress in Additive Manufacturing 2019, 4, 3 245.
[P22] Simon FRIED, Journal of the Imaging Society of Japan (NIHON GAZO GAKKAISHI) 2017, 56, 6 617.
[P23] M. N. Jahangir, J. Cleeman, C. Pan, C.-H. Chang, R. Malhotra, Journal of Manufacturing Processes 2022, 82 319.
[P24] H. W. Tan, J. An, C. K. Chua, T. Tran, Advanced Electronic Materials 2019, 5, 5 1800831.
[P25] G. L. Goh, H. Zhang, T. H. Chong, W. Y. Yeong, Advanced Electronic Materials 2021, 7, 10 2100445.
[P26] J. Wiklund, A. Karako¸c, T. Palko, H. Yig 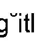 itler, K. Ruttik, R. J 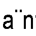 tti, J. Paltakari, Journal of Manufacturing and Materials Processing 2021, 5, 3 89.
[P27] T. V. Neumann, M. D. Dickey, Advanced Materials Technologies 2020, 5, 9 2000070.
[P28] C.-H. Wang, H.-L. Tsai, Y.-C. Wu, W.-S. Hwang, Journal of Micromechanics and Microengineering 2016, 26, 9 095012.
[P29] Z. Luo, X. Wang, L. Wang, D. Sun, Z. Li, Materials Letters 2017, 188 184.
[P30] B. Gerdes, M. Breitwieser, T. Kaltenbach, M. Jehle, J. Wilde, R. Zengerle, P. Koltay, L. Riegger, Materials Research Express 2019, 6, 3 036514.
[P31] Y. Dou, J. Luo, L. Qi, H. Lian, J. Huang, Journal of Materials Processing Technology 2021, 297 117268.
[P32] 2016 IEEE International Conference on Industrial Technology (ICIT), 2016 IEEE International Conference on Industrial Technology (ICIT). IEEE, 2016, ISBN 978-1-4673-8075-1.
[P33] K. Andersen, Y. Dong, W. S. Kim, Advanced Engineering Materials 2017, 19, 11 1700301.
[P34] Y. Yu, F. Liu, J. Liu, Rapid Prototyping Journal 2017, 23, 3 642.
[P35] B. Podsiad ly, L. Bezgan, M. S loma, Electronics 2022, 11, 22 3829.
[P36] Z. Shu, M. Fechtig, F. Lombeck, M. Breitwieser, R. Zengerle, P. Koltay, IEEE Access 2020, 8 210225.
[P37] Alan Dragomirecki, Da O., Patrick Zand, Prusa3d, 2022, URL https://github.com/orgs/prusa3d/repositories.
[P38] M.Bach, editor, 2018-01-02.
[P39] C. Barr, Rumba+, URL https://github.com/Aus3D/RUMBA-Plus.
[P40] X. Aeby, A. Poulin, G. Siqueira, M. K. Hausmann, G. Nystr 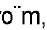 , Advanced materials (Deerfield Beach, Fla.) 2021, 33, 26 e2101328.
[P41] N. Volpato, D. Kretschek, J. A. Foggiatto, C. M. Da Gomez Silva Cruz, The International Journal of Advanced Manufacturing Technology 2015, 81, 9-12 1519.
[P42] E. Soleyman, M. Aberoumand, K. Soltanmohammadi, D. Rahmatabadi, I. Ghasemi, M. Baniassadi, K. Abrinia, M. Baghani, Manufacturing Letters 2022, 33 1.
[P43] K. Gupta, M. K. Gupta, Optimization of Manufacturing Processes, Springer Series in Advanced Manufacturing. Springer, Cham, 2019.
[P44] N. Lass, L. Riegger, R. Zengerle, P. Koltay, Micromachines 2013, 4, 1 49.
[P45] B. Gerdes, M. Jehle, N. Lass, L. Riegger, A. Spribille, M. Linse, F. Clement, R. Zengerle, P. Koltay, Solar Energy Materials and Solar Cells 2018, 180 83.
[P46] M. N. Nassajfar, I. Deviatkin, V. Leminen, M. Horttanainen, Sustainability 2021, 13, 21 12126.
[P47] S. Cheng, C.-M. Huang, M. Pecht, Microelectronics Reliability 2017, 75 77.
[P48] S. Herat, Review paper: CLEAN - Soil, Air, Water 2008, 36, 2 145.
[P49] J. Dornhof, V. Zieger, J. Kieninger, D. Frejek, R. Zengerle, G. A. Urban, S. Kartmann, A. Weltin, Lab on a chip 2022, 22, 22 4369.

[1] LaDou J 2006 Printed circuit board industry International Journal of Hygiene and Environmental Health 209 211-9
[2] 2019 Electronic Waste and Printed Circuit Board Recycling Technologies (The Minerals, Metals & Materials Series) 1st edn (Cham: Springer International Publishing)
[3] Lu B-H, Lan H-B and Liu H-Z 2018 Additive manufacturing frontier: 3D printing electronics OEA 1 17000401-10
[4] Espalin D, Muse D W, MacDonald E and Wicker R B 2014 3D Printing multifunctionality: structures with electronics Int J Adv Manuf Technol 72 963-78
[5] Khan Y, Thielens A, Muin S, Ting J, Baumbauer C and Arias A C 2020 A New Frontier of Printed Electronics: Flexible Hybrid Electronics Advanced Materials 32 e1905279
[6] Juric D, Hammerle S, Glaser K, Eberhardt W and Zimmermann A 2019 Assembly of Components on Inkjet-Printed Silver Structures by Soldering IEEE Transactions on Components, Packaging and Manufacturing Technology 9 156-62
[7] Kim M-S, Chu W-S, Kim Y-M, Avila A P G and Ahn S-H 2009 Direct metal printing of 3D electrical circuit using rapid prototyping Int. J. Precis. Eng. Manuf. 10 147-50
[8] Wang L and Liu J 2014 Compatible hybrid 3D printing of metal and nonmetal inks for direct manufacture of end functional devices Sci. China Technol. Sci. 57 2089-95
[9] Goh G L, Agarwala S, Goh G D, Tan H K J, Zhao L, Chuah T K and Yeong W Y 2018 Additively manufactured multi-material free-form structure with printed electronics Int J Adv Manuf Technol 94 1309-16
[10] Krishnanand, S, Mohammad T, 2021 Design and assembly of fused filament fabrication (FFF) 3D printers, Materials Today: Proceedings, Volume 46, Part 11, Pages 5233-5241, ISSN 2214-7853, https://doi.org/10.1016/j.matpr.2020.08.627.

## Claims

1. A method of additive manufacturing of an electronic circuit
**characterized in that**
the method comprises the steps of
providing a printing device comprising a build plate (20); a first printhead (22) configured for printing a conductive molten metal and a second printhead (24) configured for printing a non-conductive material;
printing the electronic circuit by printing conductive elements (2) from the conductive molten metal using the first printhead (22) and printing a non-conductive structure (4) using the second printhead (24) of the printing device.

2. The method of additive manufacturing of an electronic circuit according to the previous claim
**characterized in that**
the method comprises the steps of
a.) printing a non-conductive structure (4) using the second printhead (24) of the printing device; and printing conductive elements (2) onto the non-conductive structure (4) using the first printhead (22) of the printing device or
b.) printing conductive elements (2) using the first printhead (22) and printing the non-conductive structure (4) on top of the conductive elements (2) using the second printhead (24) of the printing device.

3. The method of additive manufacturing of an electronic circuit according to any one of the two preceding claims
**characterized in that**
the conductive elements (2) include conductive traces, conductive pads, conductive soldering and/or conductive interconnects.

4. The method of the any one of the three preceding claims
**characterized in that**
the method further comprises the steps of
providing a base sheet on the build plate (20) before printing the conductive elements (2) onto the base sheet and
subsequently printing the non-conductive structure (4) onto the conductive elements (2) such as to enclose the conductive elements (2) between the non-conductive structure (4) and the base sheet and
optionally removing the base sheet after printing of the non-conductive structure (4) is complete.

5. The method of any of the previous claims
**characterized in that**
the build plate (20) of the printer, a print bed and/or a base sheet is preheated before printing of the non-conductive structure (4) and/or the conductive elements (2).

6. The method of any of the previous claims
**characterized in that**
the method further comprises a step of placing electronic components (6) at predetermined locations on the non-conductive structure (4) printed using the second printhead (24) and/or the conductive elements (2), wherein the placing occurs manually or by means of a pick-and-place robot head, the pick-and-place robot head preferably forming a part of the printing device,
wherein optionally an adhesive is applied to the electronic components (6) or at the predetermined locations before placing the electronic components (6) at the predetermined locations.

7. The method of any of the previous claims
**characterized in that**
at least a portion of the conductive elements (2) is printed from a molten metal onto a non-conductive structure (4) comprising positioned electronic components (6) such as to solder and/or electrically contact and/or mechanically stabilize the electronic components (6) on the electronic circuit.

8. The method of any of the previous claims
**characterized in that**
printing the non-conductive structure (4) is carried out such as to form grooves (28) and/or recesses on a surface of the non-conductive structure, the grooves (28) and/or recesses being configured to accommodate conductive elements (2), such as conductive traces, and/or electronic components (6), and
printing the conductive elements (2) is preferably at least partially carried out such as to insert the conductive elements (2) into the grooves (28) and/or recesses.

9. The method of any of the previous claims
**characterized in that**
the method comprises repeating the steps of printing the conductive elements (2) from the conductive molten metal using the first printhead (22) and printing the non-conductive structure (4) using the second printhead (24) of the printing device such as to enclose one or more layers of conductive elements (2) between any number of non-conductive structures (4), wherein optionally electronic components (6) are placed at predetermined positions between consecutive non-conductive structures (4).

10. The method of any of the previous claims
**characterized in that**
printing the conductive elements (2) comprises a step of releasing a molten metal droplet (76) from the first printhead (22) to a surface, wherein a droplet diameter and/or a distance from a nozzle of the first printhead (22) to the surface is selected such that the molten metal droplet (76) is at a temperature higher than its melting point at the nozzle and is at a temperature substantially equal to or lower than its melting point upon reaching the surface.

11. The method of any of the previous claims
**characterized in that**
printing the conductive elements (2) comprises a step of releasing a molten metal droplet (76) from the first printhead (22) to a surface, wherein a cooling mechanism, preferably based on liquid nitrogen, is provided for actively cooling the molten metal droplet on a trajectory between the first printhead (22) and the surface.

12. The method of any of the previous claims
**characterized in that**
the conductive elements (2) are printed by drop-on-demand deposition wherein a droplet-to-droplet spacing is smaller than an average droplet diameter and is configured such that consecutive droplets merge,
wherein preferably the average droplet diameter is between 50 - 400 µm, preferably 250 - 300 µm and the droplet-to-droplet spacing is 80 - 250 µm.

13. A printing device for the additive manufacturing of an electronic circuit by a method according to any one of the preceding claims,
**characterized in that**
the printing device comprises:
a build plate (20);
a first printhead (22) configured for printing conductive elements (2) from a conductive molten metal provided;
a second printhead (24) configured for printing a non-conductive structure (4) from a dielectric material.

14. The printing device of the previous claim
**characterized in that**
the printing device further comprises a pick-and-place robot head, the pick-and-place robot head preferably being configured to place electronic components (6) at predetermined locations on a printed non-conductive structure (4) and/or printed conductive elements (2) and/or build plate (20),
wherein the printing device preferably further comprises an in-line camera configured to verify picking and placement of the electronic components (6) and/or to monitor print quality.

15. The printing device of any of the previous two claims
**characterized in that**
the first printhead (22) and/or the second printhead (24) are moveable in the z-direction with respect to the build plate (20) and/or
the build plate (20) is moveable in the z-direction with respect to the first printhead (22) and/or the second printhead (24).
